# EUROPÄISCHE PATENTSCHRIFT

(11) **EP 1 753 896 B1**
(45) Veröffentlichungstag und Bekanntmachung des Hinweises auf die Patenterteilung: **29.08.2007**
(21) Anmeldenummer: 05750428.4
(22) Anmeldetag: 04.05.2005
(51) Int. Cl.: C25D 5/02, C25D 7/06, C23C 14/04

(54) **VERFAHREN UND SYSTEM ZUM SELEKTIVEN BESCHICHTEN ODER ÄTZEN VON OBERFLÄCHEN**
METHOD AND SYSTEM FOR SELECTIVELY COATING OR ETCHING SURFACES
PROCEDE ET SYSTEME POUR LE REVETEMENT SELECTIF OU LA GRAVURE SELECTIVE DE SURFACES

(30) Priorität: 04.05.2004 DE 102004022297
(43) Veröffentlichungstag der Anmeldung: 21.02.2007
(73) Patentinhaber: OTB Oberflächentechnik in Berlin GmbH & Co., 12277 Berlin (DE)
(72) Erfinder: LANDAU, Uwe, 14169 Berlin (DE); WIEDENBECK, Rainer, 15827 Blankenfelde (DE)
(74) Vertreter: Tilger, Bernhard
(86) Internationale Anmeldenummer: PCT/DE2005/000858
(87) Internationale Veröffentlichungsnummer: WO 2005/106081

(56) Entgegenhaltungen:
- DE-A1- 3 212 152
- GB-A- 980 715
- US-A- 3 274 092
- PATENT ABSTRACTS OF JAPAN Bd. 012, Nr. 358 (C-531), 26. September 1988 (1988-09-26) & JP 63 114998 A (HITACHI CABLE LTD), 19. Mai 1988 (1988-05-19)
- PATENT ABSTRACTS OF JAPAN Bd. 006, Nr. 149 (C-118), 10. August 1982 (1982-08-10) & JP 57 070273 A (MATSUSHITA ELECTRIC IND CO LTD), 30. April 1982 (1982-04-30)

## Beschreibung

Die vorliegende Erfindung betrifft ein Verfahren zum selektiven Beschichten oder Ätzen von Oberflächen, insbesondere bei Metallbändern, metallisierten Bändern oder bandförmig angeordneten metallischen oder metallisierten Gegenständen. Sie betrifft auch ein Beschichtungs- oder Ätzsystem zur Durchführung dieses Verfahrens.

Das selektive Beschichten oder Ätzen von Oberflächen spielt in vielen technischen Bereichen eine wichtige Rolle. Es ist jedoch insbesondere bei der Herstellung elektrischer oder elektronischer Bauteile von zentraler Bedeutung, deren Leistungsfähigkeit, Qualität und Preis üblicherweise von der ordnungsgemäßen Durchführung hochpräziser Beschichtungs- und/oder Ätzschritte bestimmt wird.

Als Beispiel sei hierbei die Herstellung von Steckverbindern, berührenden oder reibenden Kontakten sowie Lead-Frames aus glatten, ebenen, flach-gestanzten oder formgestanzten Metallbändern genannt. Um die gewünschten guten Oberflächeneigenschaften, wie eine gute Kontaktgabe, Bondbarkeit und Lötfähigkeit sowie eine hohe Verschleiß- und Korrosionsbeständigkeit zu erreichen, wird ein kostengünstiges unedles Grundmaterial, wie z.B. E-Kupfer, Bronze, Messing, Neusilber, Eisen oder auch Eisenlegierungen, üblicherweise galvanisch mit Gold-, Silber, Rhodium, Palladium oder Zinn veredelt. Aus technischen und/oder wirtschaftlichen Gründen dürfen diese galvanischen Veredelungsschichten hierbei jedoch lediglich selektiv auf bestimmte Oberflächenbereiche aufgebracht werden. Das Aufbringen kann hierbei - je nach Anwendungszweck - beispielsweise sowohl in Form eines oder mehrerer einfacher Streifen als auch in Form von sogenannten "Spots" mit einer bedarfsgerechten, beliebigen geometrischen Gestaltung erfolgen. Insbesondere die zunehmende Miniaturisierung der Bauteile macht hierbei eine sehr hohe Selektivität bei hoher Präzision der Randbegrenzung der Selektiv-Beschichtung (≤ 0,1 mm) erforderlich.

Aus dem Stand der Technik sind eine ganze Reihe von Selektiv-Beschichtungs- oder Selektiv-Ätzverfahren bekannt. Im einfachsten Fall werden die entsprechend zu bearbeitenden Gegenstände oder Werkstücke durch kontrolliertes partielles Eintauchen in eine geeignete Beschichtungs- oder Ätzlösung kantenumgreifend bearbeitet. Auf diese einfache Art und Weise sind jedoch keine Streifen oder Spots oder sonstige gewünschte Strukturen auf einer Oberfläche herstellbar.

Zur Herstellung von Strukturen dieser Art werden die nicht zu beschichtenden oder zu ätzenden Oberflächenbereiche üblicherweise durch Aufbringen einer geeigneten Maskierung, wie z.B. eine dünne Maske aus Kunststoff oder Metall, geschützt, die nach dem Beschichten oder Ätzen der nicht maskierten Oberflächenbereiche mittels eines herkömmlichen Beschichtungs- oder Ätzverfahrens, wie z.B. durch Aufbürsten, Aufspritzen oder Aufsprühen eines geeigneten Beschichtungs- oder Ätzmaterials, durch Eintauchen in ein entsprechendes Material oder Medium oder durch Ausnutzung von Kapillarkräften, wieder entfernt wird.

Metallbänder der genannten Art können beispielsweise mittels einer stehenden Maske maskiert werden, in die in geöffnetem Zustand zunächst eine der Maskenlänge entsprechende Metallbandlänge eingezogen wird. Die Maske wird nun wieder geschlossen und fest auf das eingezogene ruhende Metallband gepresst, wobei dessen nicht maskierten Oberflächenbereiche nun beispielsweise selektiv galvanisch beschichtet oder einem sonstigen geeigneten Beschichtungs- oder Ätzverfahren unterworfen werden. Nach der jeweils erforderlichen Bearbeitungsdauer wird die Maske wieder geöffnet und es wird das nächste Stück Metallband eingezogen. Dieses Verfahren arbeitet üblicherweise quasikontinuierlich, wobei das Metallband vor und hinter der Maske kontinuierlich aus einer Speichereinrichtung herausläuft bzw. in eine solche hineinläuft. Diese Stop-and-Repeat-Verfahrenstechnik ermöglicht jedoch nur relativ geringe Band- und Verarbeitungsgeschwindigkeiten, so dass eine wirtschaftliche Betriebsweise häufig in Frage gestellt ist. Das Verfahren ist insbesondere zur präzisen Aufbringung von Spots geeignet. Beim galvanischen Aufbringen entsprechender Gold- oder Silberschichten lässt sich eine Präzision von etwa 0,1 mm erreichen. Galvanische Zinn und Zinn-Blei-Beschichtungen hingegen sind häufig nicht mit der gewünschten Präzision herstellbar.

Eine andere übliche Vorgehensweise besteht darin, geeignet gestaltete bewegliche Endlos-Masken- oder -Maskierungsbänder aus Gummi oder einem sonstigen geeigneten Kunststoff fest auf die zu maskierenden Oberflächenbereiche zu drücken oder zu pressen. Als Selektiv-Beschichtungs- oder Ätzsysteme können hierbei beispielsweise gerade oder gekrümmte Durchlaufzellen (sogenannte "Rainbow-Zellen") eingesetzt werden. Die Selektiv-Beschichtungs- oder Ätzsysteme können jedoch auch radförmig ausgebildet sein und sowohl stehend als auch liegend angeordnete Räder umfassen. Die hierbei erreichbare Präzision (≥ 0,1 mm) ist jedoch insbesondere für die Halbleitertechnik in der Regel nicht ausreichend.

Als Sonderform dieser Selektiv-Verfahren ist auch die sogenannte Mylar-Technik bekannt, bei der eine dünne bandförmige Mylar-Folie auf ein beispielsweise galvanisch zu beschichtendes, ebenes glattes Metallband gepresst wird.

Bei ebenen glatten Metallbändern besteht auch die Möglichkeit, die Oberfläche durch Aufkleben eines einseitig klebenden Maskierungsbandes bedarfsgerecht zu maskieren. Dieses Klebeband wird nach erfolgter Bearbeitung der Oberfläche wieder abgezogen und verworfen. Bei manchen Anwendungen, wie z.B. beim galvanischen Beschichten, entsteht zudem häufig zu entsorgender Sondermüll, so dass das Verfahren recht teuer ist. Die Präzision der Beschichtungen liegt im Randbereich bei etwa 0,1 mm.

Aus dem Stand der Technik ist auch der Einsatz von Magnetkräften zum Maskieren von Metallbändern bekannt.

Die DE-OS-21 34 245 offenbart beispielsweise ein Verfahren zum kontinuierlichen, einseitigen, vollflächigen galvanischen Beschichten eines ferromagnetischen Stahlbandes. Die nicht zu beschichtende Rückseite des Stahlbandes wird hierbei mit einem bandförmigen flexiblen Blattmagneten vollständig abgedeckt, wobei die beiden Bänder durch eine magnetische Wechselwirkung flüssigkeitsdicht aneinander haften. Die beiden Bänder werden nun durch einen Elektroplattierungsbad geleitet, in dem die freie Vorderseite des Stahlbandes vollständig galvanisch beschichtet wird. Nach erfolgter Galvanisierung müssen die beiden Bänder unter Überwindung der Magnetkraft auseinandergeschält werden, was für dünne beschichtete Bänder die nicht unerhebliche Gefahr eines Verziehens mit sich bringt. Die verwendeten Blattmagnete bestehen aus einem thermoplastischen Kunstharz mit einem eingelagerten magnetisierbaren Pulver, wie z.B. ein Bariumferrit-Pulver, das auf geeignete Art und Weise magnetisiert wird. Der erreichbaren Magnetkraft sind hierbei jedoch Grenzen gesetzt.

Die DE 32 12 152 C2 offenbart eine Vorrichtung zum einseitigen, selektiven galvanischen Beschichten eines Metallbandes. Die bekannte Vorrichtung umfaßt ein Trägerband für das zu beschichtende Metallband sowie ein oder mehrere, zueinander parallel laufende, endlose ferromagnetische Maskierungs- oder Maskenbänder zum Maskieren der dem Trägerband gegenüberliegenden Bandseite. Diese Maskenbänder werden durch einen oder mehrere unter dem Trägerband angeordnete Permanent- oder Elektromagnete flüssigkeitsdicht auf das Metallband gepresst, so daß dieses anschließend in den nicht maskierten Oberflächenbereichen selektiv galvanisch beschichtet werden kann. Das Metallband selbst muß hierbei keinerlei ferromagnetischen Eigenschaften besitzen, da die Maskierung auf einer magnetischen Wechselwirkung zwischen den fest installierten Permanent- oder Elektromagneten und den ferromagnetischen Maskenbändern beruht. Diese bestehen jeweils aus einem ferromagnetischen Stahlband, das allseitig mit einer dünnen gummielastischen Beschichtung versehen ist. In der industriellen Praxis erweisen sich diese Maskenbänder jedoch als nicht dauerhaft haltbar, so dass die bekannte Vorrichtung nicht für einen Dauerbetrieb nutzbar ist. Dies beruht darauf, daß die ferromagnetischen Stahlbänder bei der erforderlichen Umlenkung der Maskenbänder in ihren Kunststoff-Ummantelungen zu arbeiten beginnen und diese nach einiger Zeit verschleißen.

Die US 3 274 092 A offenbart eine Vorrichtung zum selektiven galvanischen Beschichten metallischer Schmalbänder, die beidseitig mit einem magnetischen Endlos-Maskierungsband maskiert und kontinuierlich durch ein Galvanisierungsbad geleitet werden. Die Maskierungsbänder sind hierbei etwas schmäler ausgebildet als die zu galvanisierenden Schmalbänder, so dass diese ausschließlich an ihren nicht maskierten Kanten beschichtet werden. Die Maskierungsbänder können aus einem magnetischen Stahlkern mit einer Kunststoff-Ummantelung aus Polyamid, Teflon oder einem anderen synthetischen Material bestehen. Sie können jedoch auch als Kunststoffband mit eingelagerten magnetischen Partikeln ausgebildet sein.

In der JP 63114998 A (PATENT ABSTRACTS OF JAPAN, Bd. 012, Nr. 358 (C-531), 26. September 1988) wird eine Vorrichtung zum selektiven galvanischen Beschichten von Metallbändern beschrieben, die beidseitig mit einem nichtmagnetischen Endlos-Maskierungsband maskiert und zum Galvanisieren der nicht maskierten Oberflächenbereiche kontinuierlich durch ein Galvanisierungsbad geleitet werden. Die beiden Maskierungsbänder werden hierbei durch zwei Endlos-Magnetbänder flüssigkeitsdicht angepresst, die auf ihren oberflächenabgewandten Rückseiten angeordnet sind und synchron mit ihnen angetrieben werden. Die Endlos-Magnetbänder sind auf den mit den Maskierungsbändern in Eingriff tretenden Oberflächen mit Magneten versehen.

Die GB 980 715 A offenbart ein Verfahren und eine Vorrichtung zum chemischen Beschichten von Substraten. Die Substrate werden hierbei mit einer dünnen ersten Maske maskiert, die gegebenenfalls ferromagnetisch ausgebildet sein kann. Auf diese dünne erste Maske wird eine dickere zweite Maske aufgebracht, die ferromagnetisch ausgebildet ist und die erste Maske durch eine magnetische Wechselwirkung mit einem hinter den Substraten angeordneten Magneten flüssigkeitsdicht andrückt.

Die Aufgabe der vorliegenden Erfindung besteht in der Schaffung eines möglichst einfachen, flexiblen, kostengünstigen und wirtschaftlichen neuartigen Selektiv-Beschichtungs- oder Ätzverfahrens hoher Präzision. Das gesuchte Verfahren soll insbesondere bei Metallbändern, metallisierten Bändern oder bandförmig angeordneten metallischen oder metallisierten Gegenständen zum Maskieren nicht zu bearbeitender Oberflächenbereiche bei einer nachfolgenden selektiven Galvanisierung oder einem selektiven Ätzen von Metalloberflächen geeignet sein. Es soll hierbei eine kontinuierliche Betriebsweise mit hohen Bandgeschwindigkeiten und hohen Standzeiten ermöglichen. Die Aufgabe besteht auch in der Schaffung eines sehr präzisen, hinreichend dichten, verschleißfesten und wiederverwendbaren Maskierungssystems sowie eines Beschichtungs- oder Ätzsystems zur Durchführung dieses Verfahrens.

Diese Aufgabe wird erfindungsgemäß durch ein Verfahren nach Anspruch 1 gelöst.

Bei dem vorliegenden erfindungsgemäßen Selektiv-Beschichtungs- oder -Ätzverfahren werden die nicht zu beschichtenden oder zu ätzenden Oberflächenbereiche während des eigentlichen Beschichtungs- oder Ätzvorganges auf an sich bekannte Art und Weise mit einer geeignet gestalteten Maskierungseinrichtung abgedeckt. Die Maskierungseinrichtung wird hierbei durch magnetische Kräfte flüssigkeitsdicht angedrückt oder angepresst, so dass die maskierten Oberflächenbereiche zuverlässig vor unerwünschten Beschichtungs- oder Ätzspuren geschützt sind. Die nicht maskierten Oberflächenbereiche können dann auf bekannte Art und Weise selektiv beschichtet, wie z.B. insbesondere galvanisiert, oder geätzt werden. Das Beschichten oder Ätzen kann hierbei prinzipiell auf beliebige bekannte Art und Weise erfolgen, wie beispielsweise durch Aufspritzen, Aufsprühen, Aufpinseln oder Aufwalzen eines geeigneten flüssigen Beschichtungs- oder Ätzmediums, durch Eintauchen in dieses Medium oder Material oder durch Ausnutzung von Kapillarkräften.

Die für eine ordnungsgemäße flüssigkeitsdichte Maskierung erforderlichen Andrück- oder Anpresskräfte werden durch eine magnetische Wechselwirkung zwischen einer Magneteinrichtung und einer zugeordneten Gegen-Magneteinrichtung erzeugt, von denen zumindest eine auf der oberflächenabgewandten Seite der Maskierungseinrichtung angeordnet ist. Die Magneteinrichtung und die Gegen-Magneteinrichtung sind hierbei so ausgelegt und so angeordnet, dass eine maximale Magnetkraft und damit auch eine maximale Andrück- oder Anpresskraft gegeben ist.

Durch die Verwendung zweier magnetisch miteinander wechselwirkender Magneteinrichtungen zum Andrücken oder Anpressen der Maskierungseinrichtung kann diese vorzugsweise auch aus einem nicht magnetischen oder nicht magnetisierbaren Kunststoffmaterial bestehen. Dieses kann sehr dünn ausgebildet werden, so dass sehr präzise Beschichtungs- oder Ätzstrukturen herstellbar sind. In der Praxis haben sich insbesondere Maskierungseinrichtungen aus Polytetrafluorethylen (PTFE) mit einer Dicke von etwa 0,1 - 2 mm bewährt, da dieses Material nicht nur hinreichend gut thermisch beständig sondern auch - wie z.B. gegen alle technisch relevanten Elektrolyten - ausreichend chemikalienfest ist. Es ist zudem auch noch sehr verschleißfest und durch einen niedrigen Reibwert charakterisiert. Ein weiterer Vorteil dieses Materials, besteht darin, dass eventuell anhaftende Beschichtungs- oder Ätzflüssigkeit, wie z.B. Elektrolytflüssigkeit, durch die Hydrophobie des Materials mit geeigneten Luftabstreifereinrichtungen leicht vollständig abgeblasen oder durch geeignete Abstreifer abgestreift werden kann, so dass sie bei einem nachfolgenden Maskierungsvorgang nicht unerwünschterweise mit auf die zu maskierende Oberfläche aufgetragen wird, was mit einer entsprechenden Verringerung der Selektivität verbunden wäre. Es können vorzugsweise jedoch auch Maskierungseinrichtungen aus einem sonstigen geeigneten Kunststoff mit vergleichbar guten Materialeigenschaften oder aus einem insbesondere einseitig oder beidseitig mit Kunststoff beschichteten nicht ferromagnetischen Metall bzw. einer entsprechenden Metalllegierung, wie z.B. Edelstahl, verwendet werden. Metallische oder metallhaltige Maskierungseinrichtungen werden hierbei zur Verhinderung ungewollter Beschichtungen vorzugsweise elektrisch isoliert.

Diese Maskierungseinrichtungen können prinzipiell beliebig gestaltet oder geformt und mit einer geeigneten Strukturierung beliebiger Art oder Geometrie versehen sein. Zum Bearbeiten von Metallbändern wird insbesondere eine bandförmig ausgebildete Maskierungseinrichtung verwendet, die vorzugsweise als Endlosband gestaltet ist. Sie kann gegebenenfalls auch mehrteilig ausgebildet sein, wie beispielsweise bei der Herstellung von Streifen, wo mehrere sich parallel zueinander erstreckende Maskierungs- oder Maskenbänder eingesetzt werden.

Bei einer bevorzugten Verfahrensvariante werden zwei sich gegenüberliegende Oberflächenbereiche gleichzeitig maskiert und anschließend beschichtet oder geätzt. Hierzu wird eine Maskierungseinrichtung mit einer Maske und einer Gegen-Maske verwendet, die gleichzeitig auf die beiden Oberflächen aufgebracht werden.

Vorzugsweise werden auch eine mit Polytetrafluorethylen (PTFE) oder einem vergleichbaren Kunststoff beschichtete Magneteinrichtung und eine entsprechend beschichtete Gegen-Magneteinrichtung verwendet. In der Praxis haben sich auch hierbei Beschichtungen mit einer Dicke von etwa 0,1 - 2 mm besonders bewährt.

Bei einer bevorzugten Verfahrensvariante werden zwei magnetisch gegenpolig zueinander ausgebildete Magneteinrichtungen verwendet, von denen eine auf der oberflächenabgewandten Rückseite der Maskierungseinrichtung angeordnet wird, während sich die andere auf der Oberflächen-Kontaktseite der Maskierungseinrichtung befindet. Eine der beiden Magneteinrichtungen kann hierbei beispielsweise ein geeignetes ferromagnetisches Material, wie z.B. kunststoffbeschichtetes Eisen, umfassen, während die zugeordnete andere (Gegen)-Magneteinrichtung einen oder mehrere Permanent- oder Elektromagnete oder auch Haftmagnete mit elektrischer Abschaltung umfasst. Die Magneteinrichtung und die Gegen-Magneteinrichtung können jedoch auch jeweils einen oder mehrere Permanent- oder Elektromagnete umfassen, die gegenpolig zueinander so angeordnet werden, dass sich eine maximale magnetische Anziehungskraft zwischen den beiden Magneteinrichtungen ergibt. In den Magneteinrichtungen kann gegebenenfalls auch ein magnetisierbares und auf an sich bekannte geeignete Art und Weise magnetisiertes Material, wie beispielsweise ein in Kunststoff eingelagertes Bariumferrit-Pulver oder dergleichen, eingesetzt werden.

Bei Verwendung von Elektromagneten können die Haft- oder Anpresskräfte in Abhängigkeit von dem jeweiligen Maskierungsproblem - beispielsweise in Abhängigkeit von der Dicke und der Verbiegungsempfindlichkeit des eingesetzten Materials - passend gewählt und bedarfsgerecht eingestellt werden.

Es können jedoch auch auf der oberflächenabgewandten Rückseite der Maskierungseinrichtung zwei magnetisch gleichpolig zueinander ausgebildete Magneteinrichtungen angeordnet werden. Die Position und die Magnetstärke der beiden sich abstoßenden Magneteinrichtungen wird hierbei so gewählt, dass eine von ihnen mit der für eine ordnungsgemäße Maskierung erforderlichen hohen Andrück- oder Anpresskraft auf die Maskierungseinrichtung gedrückt wird. Die Magneteinrichtung und die Gegen-Magneteinrichtung können hierbei wiederum jeweils einen oder mehrere Permanent- oder Elektromagnete geeigneter Magnetstärke umfassen.

Beim Beschichten oder Ätzen von magnetischen oder magnetisierbaren Gegenständen oder Werkstücken können diese gegebenenfalls auch selbst als Magneteinrichtung für eine auf der oberflächenabgewandten Seite der Maskierungseinrichtung angeordnete und geeignet gestaltete Gegen-Magneteinrichtung verwendet werden. Die Maskierungseinrichtung wird hierbei durch eine anziehende magnetische Wechselwirkung zwischen der Gegen-Magneteinrichtung und den magnetischen oder auf an sich bekannte geeignete Art und Weise magnetisierten Gegenständen oder Werkstücken auf deren Oberfläche gedrückt oder gepreßt.

Für spezielle Anwendungen kann gegebenenfalls auch eine magnetische oder magnetisierbare Maskierungseinrichtung eingesetzt und als Magneteinrichtung für eine auf ihrer oberflächenabgewandten Seite angeordnete Gegen-Magneteinrichtung verwendet werden. Die Gegen-Magneteinrichtung und die Maskierungseinrichtung werden hierbei wieder magnetisch gegenpolig zueinander gewählt, so dass diese durch die abstoßenden Magnetkräfte flüssigkeitsdicht gegen die Oberfläche gedrückt oder gepresst wird.

Als Magneteinrichtung und/oder als Gegen-Magneteinrichtung wird vorzugsweise ein Magnetkopf mit einem oder mehreren geeignet angeordneten Permanent- oder Elektromagneten verwendet, wobei der Einsatz von Elektromagneten aus den oben bereits genannten Gründen, wie z.B. die größere Flexibilität bei der Anpassung an unterschiedliche Beschichtungs- oder Ätzprobleme, zu bevorzugen ist.

Bei einer bevorzugten Verfahrensvariante werden (Endlos)-Metallbänder, metallisierte Bändern oder bandförmig angeordnete metallische oder metallisierte Gegenstände beschichtet oder geätzt. Die Magneteinrichtung und/oder die Gegen-Magneteinrichtung sind hierbei gleichfalls bandförmig ausgebildet; sie sind hierbei insbesondere als Endlosband ausgestaltet.

Das Beschichtungs- oder Ätzmaterial wird vorzugsweise kontinuierlich im Kreislauf geführt, wobei es zur Gewährleistung einer stets gleichbleibend hohen Beschichtungs- oder Ätzqualität filtriert wird. Zudem werden eventuell vorhandene ferromagnetische Metallpartikel magnetisch abgeschieden. Verbrauchtes Material wird hierbei durch frisches ersetzt.

Nach dem Beschichten oder Ätzen der Oberflächen ist vorzugsweise auch noch ein Entmagnetisierungsschritt für die zu verarbeitenden Gegenstände und für eventuell vorhandene Gegenmetalle in einer Magneteinrichtung oder in der Maskierungseinrichtung vorgesehen.

Das Beschichten oder Ätzen erfolgt vorzugsweise unter magnetischer Abschirmung oder Isolation, um unerwünschte magnetische Einflüsse auf benachbarte elektrische oder elektronische Geräte zu vermeiden.

Erfindungsgemäß werden unzulässig starke Krafteinwirkungen auf zu beschichtende oder zu ätzende Gegenstände erfaßt und durch eine Veränderung der Betriebsparameter des jeweiligen Maskierungssystems automatisch kompensiert. z.B. durch eine Anpassung oder Synchronisation der Bandgeschwindigkeiten beim nachstehend noch ausführlich beschriebenen Maskieren eines auf einem Trägerband geführten Endlos-Metallbandes mit einem geeigneten Maskenband. Die Erfassung der Krafteinwirkungen erfolgt hierbei insbesondere anhand einer Bewegung der Magneteinrichtung und/oder der Gegen-Magneteinrichtung, die - beispielsweise auf einer beweglichen Schlitteneinrichtung - beweglich gelagert werden. Diese Bewegung wird vorzugsweise magnetisch gebremst und begrenzt.

Ein Maskierungssystem zur Durchführung dieses Verfahrens umfasst eine Maskierungseinrichtung zum Maskieren nicht zu beschichtender oder zu ätzender Oberflächenbereiche mit einer Vorderseite oder Oberflächen-Kontaktseite, die mit diesen Oberflächenbereichen in Kontakt bringbar ist oder in Kontakt steht, und mit einer oberflächenabgewandten gegenüberliegenden Rückseite. Diese Maskierungseinrichtung kann aus einem beliebigen, hinreichend chemikalienbeständigen, d.h. beschichtungs- oder ätzmaterialbeständigen, ausreichend flexiblen, formstabilen und verschleißfesten Material bestehen und je nach Anwendungszweck bedarfsgerecht ausgebildet oder geformt sein. Sie besteht vorzugsweise aus einem geeigneten Kunststoff, wie beispielsweise Polytetrafluorethylen (PTFE) oder dergleichen mit einer Dicke von etwa 0,1 - 2 mm. Sie kann gegebenenfalls jedoch auch aus einem geeigneten kunststoffbeschichteten Metall oder einer Metalllegierung bestehen, die auch ferromagnetisch ausgebildet sein können. In einer bevorzugten erfindungsgemäßen Ausgestaltung ist die Maskierungseinrichtung bandförmig ausgebildet; sie ist hierbei insbesondere als Endlosband gestaltet.

Die Maskierungseinrichtung kann auch mehrere einzelne Masken oder Maskeneinrichtungen - wie beispielsweise mehrere parallel zueinander angeordnete (Endlos-) Masken- oder Maskierungsbänder - umfassen, die so angeordnet und gestaltet sind, dass sie zusammen die gewünschte Maskierungsstruktur ergeben. Die Maskierungseinrichtung kann insbesondere auch zumindest eine Maske und zumindest eine zugeordnete Gegenmaske zum gleichzeitigen Maskieren-zweier-gegenüberliegender -Oberflächenbereiche umfassen.

Das Maskierungssystem umfasst zudem eine Magneteinrichtung und eine Gegen-Magneteinrichtung, die so ausgebildet und angeordnet sind, dass die beschriebene Maskierungseinrichtung durch eine magnetische Wechselwirkung zwischen den beiden Magneteinrichtungen flüssigkeitsdicht auf die zu maskierenden Oberflächenbereiche gepreßt wird oder aufpreßbar ist. Hierbei ist zumindest eine dieser beiden Magneteinrichtungen auf der oberflächenabgewandten Rückseite der Maskierungseinrichtung so angeordnet, dass sie zur Übertragung der erforderlichen Andrück- oder Anpresskräfte mit dieser in Kontakt bringbar ist oder in Kontakt steht.

Bei einer bevorzugten Ausführungsform sind die beiden Magneteinrichtungen magnetisch gegenpolig zueinander ausgebildet und beidseitig der Maskierungseinrichtug angeordnet. Eine der beiden Magneteinrichtungen befindet sich somit auf der oberflächenabgewandten Rückseite der Maskierungseinrichtung, während die zugeordnete Gegen-Magneteinrichtung auf der Oberflächen-Kontaktseite der Maskierungseinrichtung angeordnet ist. Die Gegen-Magneteinrichtung und die Maskierungseinrichtung sind hierbei so zueinander beabstandet, dass sich zu maskierende bzw. zu ätzende oder zu beschichtende Gegenstände zwischen sie bringen lassen oder dort befinden.

Eine der beiden Magneteinrichtungen kann hierbei beispielsweise ein ferromagnetisches Material umfassen, während die zugeordnete Gegen-Magneteinrichtung einen oder mehrere Permanent- oder Elektromagnete umfasst. Die Magneteinrichtung und die Gegen-Magneteinrichtung können jedoch auch jeweils ein oder mehrere miteinander wechselwirkende Permanent- oder Elektromagnete oder ein magnetisierbares und auf geeignete Art und Weise magnetisiertes Material umfassen.

Die beiden Magneteinrichtungen können jedoch auch magnetisch gleichpolig zueinander ausgebildet und beide auf der oberflächenabgewandten Rückseite der Maskierungseinrichtung angeordnet sein. Die Position und die Magnetstärke der beiden Magneteinrichtungen wird hierbei so gewählt, dass eine von ihnen durch die abstoßenden Magnetkräfte mit der für eine ordnungsgemäße Maskierung erforderlichen hohen Andrückkraft auf die Maskierungseinrichtung gedrückt wird oder drückbar ist. Die Magneteinrichtung und die Gegen-Magneteinrichtung können hierbei beispielsweise jeweils einen oder mehrere Permanent- oder Elektromagnete umfassen.

Gegebenenfalls kann jedoch auch die Maskierungseinrichtung selbst magnetisch ausgebildet sein und als erfindungsgemäße Magneteinrichtung für eine auf ihrer oberflächenabgewandten Rückseite angeordnete gegenpolige Gegen-Magneteinrichtung dienen. Die Maskierungseinrichtung ist hierbei mit einer der entsprechend dem vorigen Absatz zu ihrem Andrücken erforderlichen Magneteinrichtungen als Einheit ausgebildet.

Die Magneteinrichtungen und/oder die Maskierungseinrichtung können gegebenenfalls auch ein magnetisierbares und auf geeignete Art und Weise magnetisiertes Material, wie beispielsweise ein in Kunststoff eingelagertes Bariumferrit-Pulver oder dergleichen, umfassen.

Die Magneteinrichtung und/oder die Gegen-Magneteinrichtung sind vorzugsweise bandförmig ausgebildet; sie sind hierbei insbesondere als Endlosband ausgestaltet.

In einer bevorzugten Ausgestaltung sind die Permanent- oder Elektromagnete bei zumindest einer der beiden Magneteinrichtungen in Form eines Magnetkopfes angeordnet.

Die Magneteinrichtung und/oder die Gegen-Magneteinrichtung sind vorzugsweise mit Polytetrafluorethylen (PTFE) beschichtet oder mit einem anderen vergleichbar gut thermisch beständigen, chemikalien- und verschleißfesten Kunststoff mit einem entsprechend niedrigen Reibungswert. Die Dicke dieser Beschichtung beträgt insbesondere etwa 0,1 - 2 mm.

Ein Beschichtungs- oder Ätzsystem zur Durchführung des beschriebenen Verfahrens umfasst außer einem Maskierungssystem der beschriebenen Art auch noch eine Halte-, Führungs- und/oder Transporteinrichtung für zu beschichtende oder zu ätzende Gegenstände sowie eine Beschichtungs- oder Ätzeinrichtung.

Die Beschichtungs- oder Ätzeinrichtung kann hierbei eine beliebige, für den jeweiligen speziellen Anwendungszweck geeignete herkömmliche Beschichtungs- oder Ätzeinrichtung, wie beispielsweise eine Aufspritz-, Aufsprüh-, Aufpinsel-, Aufwalz-, Eintauch- oder Kapillareinrichtung für das jeweilige Beschichtungs- oder Ätzmaterial umfassen. Die Beschichtungseinrichtung ist vorzugsweise als Elektrolyseeinrichtung ausgebildet.

Die Halte-, Führungs- und/oder Transporteinrichtung ist insbesondere für die Verarbeitung von metallbändern, metallisierten Bändern oder bandförmig angeordneten metallischen oder metallisierten Gegenständen ausgebildet.

Erfindungsgemäß umfasst das Beschichtungs- oder Ätzsystem auch noch eine Schlitteneinrichtung mit einer automatischen Positioniereinrichtung und eine Sensoreinrichtung zur Erfassung der Schlittenbewegung. Die Positioniereinrichtung umfasst vorzugsweise magnetisch abstoßende Positioniermagnete, die so angeordnet sind, dass sie die Schlittenbewegung abbremsen oder begrenzen. Die Sensoreinrichtung ist mit einer Steuerungs- oder Korrektureinrichtung verbunden, welche die Sensorsignale erfasst und unerwünschte oder unzulässige Betriebsbedingungen, wie beispielsweise ein zu starker Bandzug bei (Endlos)-Metallbändem, durch eine Veränderung der Betriebsparameter automatisch kompensiert, z.B. durch eine Anpassung oder Synchronisation der Bandgeschwindigkeiten.

Schließlich ist auch noch eine Steuerungseinrichtung vorgesehen.

In einer bevorzugten Ausgestaltung umfasst das Beschichtungs- oder Ätzsystem zudem vorzugsweise auch noch eine Filtereinrichtung zum Filtrieren des verwendeten Beschichtungs- oder Ätzmaterials und/oder eine Abscheideeinrichtung zum Abscheiden eventuell vorhandener ferromagnetischer Metallpartikel.

Das Beschichtungs- oder Ätzsystem umfasst vorzugsweise auch noch eine Entmagnetisierungseinrichtung für die zu verarbeitenden Gegenstände.

Ferner kann auch noch eine Einrichtung zum magnetischen Abschirmen oder Isolieren des Systems vorgesehen sein, um empfindliche elektrische oder elektronische Geräte in der näheren Umgebung zu schützen.

Weitere Einzelheiten, Merkmale und Vorteile der vorliegenden Erfindung ergeben sich nicht nur aus den zugehörigen Ansprüchen - für sich und/oder in Kombination - sondern auch aus der nachfolgenden Beschreibung bevorzugter, beispielhafter erfindungsgemäßer Ausführungsbeispiele in Verbindung mit den zugehörigen Zeichnungen. In den Zeichnungen, in denen gleiche Bauteile mit gleichen Bezugszeichen versehen sind, zeigen in schematischer Darstellung:
- Fig. 1: eine Draufsicht auf ein erstes erfindungsgemäßes Maskierungs- und Selektiv-Beschichtungssystem zum einseitigen, selektiven galvanischen Beschichten eines Endlos-Metallbandes;
- Fig. 2: eine Draufsicht auf ein zweites erfindungsgemäßes Maskierungssystem zum zweiseitigen Maskieren eines Endlos-Metallbandes;
- Fig. 3: eine Draufsicht auf ein drittes erfindungsgemäßes Maskierungssystem zum einseitigen Maskieren eines ferromagnetischen Endlos-Metallbandes;
- Fig. 4: eine Draufsicht auf ein viertes erfindungsgemäßes Maskierungssystem zum einseitigen Maskieren eines Endlos-Metallbandes; und
- Fig. 5: eine Draufsicht auf ein fünftes erfindungsgemäßes Maskierungssystem zum einseitigen Maskieren eines Endlos-Metallbandes mittels eines magnetischen Maskenbandes.

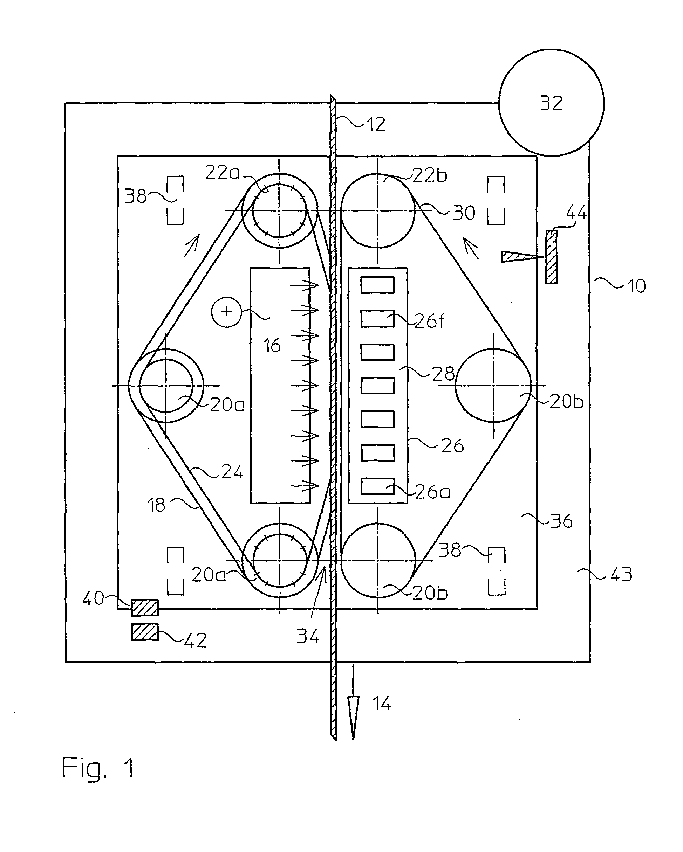

Bei dem in Fig. 1 dargestellten Selektiv-Beschichtungssystem 10 wird ein zu beschichtendes Endlos-Metallband 12 von einer (nicht dargestellten) Vorratsrolle oder Vorratsvorrichtung abgewickelt, in Richtung des Pfeils 14 mit einer bestimmten Geschwindigkeit entlang eines Führungsweges im Durchzugsverfahren von oben nach unten durch das Selektiv-Beschichtungssystem 10 geführt, in dem es mit der gewünschten, selektiven galvanischen Beschichtung versehen wird, und anschließend wieder auf eine (ebenfalls nicht dargestellte) Aufwickelrolle oder Aufwickelvorrichtung aufgewickelt.

In einem bestimmten Abstand bezüglich des Führungsweges für das Endlos-Metallband 12 ist in dem Selektiv-Beschichtungssystem 10 ein Anoden-Anspritzkopf 16 zum Aufspritzen eines geeigneten Elektrolyten auf die ihm zugewandte, zu beschichtende Vorderseite des Endlos-Metallbandes 12 angeordnet. Der Anoden-Anspritzkopf 16 ist über eine (nicht dargestellte) erste Verbindungsleitung oder Zuführungsleitung mit einem (ebenfalls nicht dargestellten) Vorratsbehälter oder Vorratstank für den Elektrolyten verbunden. Der Vorratsbehälter ist wiederum über eine (nicht dargestellte) zweite Verbindungsleitung oder Sammelleitung mit einem unter dem Anoden-Anspritzkopf 16 angeordneten (ebenfalls nicht dargestellten) Auffang- oder Sammelbehälter für den von der Metallband-Oberfläche des Endlos-Metallbandes 12 ablaufenden oder abtropfenden Elektrolyten verbunden. Dieser überschüssige oder verbrauchte Elektrolyt wird über die zweite Verbindungsleitung zur erneuten Verwendung in den Vorratsbehälter zurückgeführt. Die Zusammensetzung und die Menge des Elektrolyten in dem Vorratsbehälter wird hierbei überwacht und gegebenenfalls durch Zufuhr frischer Elektrolytflüssigkeit korrigiert.

Zur Gewährleistung einer stets ausreichend hohen Elektrolytqualität sind in diesen Elektrolyt-Kreislauf noch eine (nicht dargestellte) Filtereinrichtung und ein (ebenfalls nicht dargestellter) Magnetabscheider zum Abscheiden unerwünschter, feiner ferromagnetischer Metallpartikel, wie z.B. Eisen- oder Nickelpartikel, integriert, die bei manchen Beschichtungs- oder Metallbandmaterialien in den Beschichtungselektrolyten eingetragen werden können. Ansonsten bestünde die Gefahr, dass diese Partikel auf die zu beschichtenden Oberflächen angezogen werden.

Um den Anoden-Anspritzkopf 16 wird ein Maskierungs- oder Maskenband 18 über Umlenk- oder Führungsrollen 20a und über eine Positionierrolle 22a im Uhrzeigersinn so im Kreis geführt, dass es im Bereich des Anoden-Anspritzkopfes 16 parallel zu dem Endlos-Metallband 12 verläuft und dort - infolge einer nachstehend noch beschriebenen magnetischen Wechselwirkung zwischen einem Masken-Andrückband 24 und einem Magnetkopf 26 - flüssigkeitsdicht auf die zu beschichtende Vorderseite des Endlos-Metallbandes 12 gepreßt wird.

Die Positionierrolle 22a ist mit Stiften zur ordnungsgemäßen Positionierung des Maskenbandes 18 bezüglich des zu beschichtenden Endlos-Metallbandes 12 und zur Synchronisierung dieser beiden Bänder 12 und 18 versehen. Die Positionierrolle 22a ist mit einem geeigneten nichtleitenden Material, wie z.B. Keramik, ausgeführt.

Das Maskenband 18 besteht aus gewebeverstärktem Polytetrafluorethylen (PTFE) mit einer Dicke von 0,2 mm, da PTFE, wie oben bereits erwähnt wurde, einerseits eine hinreichend hohe Korrosionsbeständigkeit gegenüber allen üblicherweise eingesetzten Elektrolyten besitzt und andererseits einen niedrigen Reibwert aufweist. Das Maskenband 18 kann gegebenenfalls auch aus einem einseitig oder beidseitig kunststoffbeschichteten, nicht ferromagnetischen Metallband, z.B. aus Edelstahl, bestehen. Das Maskenband 18 ist mit geeigneten Spots für die gewünschte Selektiv-Beschichtung versehen, die je nach Anwendungszweck beliebig geformt oder gestaltet sei können. Zur Verhinderung ungewollter Beschichtungen ist das Maskenband 18 elektrisch isoliert Das Maskenband 18 kann bei Bedarf . wie z.B. bei der Herstellung von Streifen, gegebenenfalls jedoch auch mehrere einzelne sich parallel zueinander erstreckende Maskenbänder 18 umfassen.

Auf der dem Endlos-Metallband 12 abgewandten und dem Anoden-Anspritzkopf 16 zugewandten Rückseite des Maskenbandes 18 ist ein Masken-Andrückband 24 angeordnet, das synchron mit dem Maskenband 18 über die Umlenk- oder Führungsrollen 20a und über die Positionierrolle 22a bewegt wird. Bei dem Masken-Andrückband 24 handelt es sich um ein vollständig mit PTFE beschichtetes ferromagnetisches Eisenband. Das Masken-Andrückband 24 kann gegebenenfalls auch mehrere in das Band 24 integrierte Permanentmagnete geeigneter Polung und Magnetstärke umfassen. Es kann gegebenenfalls auch ein magnetisierbares Material, wie beispielsweise ein in einem geeigneten Kunststoff eingelagertes Bariumferrit-Pulver oder dergleichen, umfassen, das in einer Magnetisiereinrichtung magnetisiert wird. Das Masken-Andrückband 24 kann bei manchen Anwendungszwecken auch mehrere geeignet gestaltete, parallel zueinander geführte einzelne Masken-Andrückbänder 24 umfassen.

Benachbart zu dem Anoden-Anspritzkopf 16 ist auf der gegenüberliegenden Seite des Führungsweges für das Endlos-Metallband 12 ein mit dem Masken-Andrückband 24 magnetisch wechselwirkender. Magnetkopf 26 mit mehreren äquidistant zueinander angeordneten Elektromagneten 26a - 26g so angeordnet, dass zwischen dem Anoden-Anspritzkopf 16 und dem Magnetkopf 26 ein hinreichend breiter Spalt zur Durchführung des zu beschichtenden Endlos-Metallbandes 12 und der übrigen genannten Bänder 18, 24 und 30 gebildet wird. Der Magnetkopf 26 ist mit einer etwa 2mm dicken PTFE-Beschichtung 28 versehen. Er kann jedoch gegebenenfalls auch mit einem anderen geeigneten Material, wie beispielsweise Keramik, beschichtet sein.

Durch die Verwendung von Elektromagneten 26a - 26g können die Haftkräfte dem jeweiligen Beschichtungsproblem leicht angepasst und beispielsweise in Abhängigkeit von der jeweiligen Dicke und Verbiegungsempfindlichkeit des Endlos-Metallbandes 12 geeignet gewählt und bedarfsgerecht eingestellt werden. Gegebenenfalls können in dem Magnetkopf 26 jedoch auch mehrere geeignete Permanentmagnete verwendet werden.

Die Magnete 26a - 26g in dem Magnetkopf 26 sind so angeordnet, dass sich Metallbandadern in Masken-Andrückbändern 24 beim Aufbringen von Streifenbeschichtungen in Nord-/Südpolrichtung der Magnete 26a - 26g erstrecken, um eine mögliche seitliche Abstoßung der parallelen Bänder 24 zu vermeiden.

Um den Magnetkopf 26 wird ein aus gewebeverstärktem PTFE bestehendes und von einem Elektromotor 32 angetriebenes Trägerband 30 über Umlenk- oder Führungsrollen 20b und eine Positionierrolle 22b entgegen dem Uhrzeigersinn so im Kreis geführt, dass es zwischen dem Magnetkopf 26 und dem Anoden-Anspritzkopf 16 parallel zu dem Endlos-Metallband 12 verläuft. Die Positionierrolle 22b, die ebenfalls mit einem geeigneten nicht leitenden Material, wie z.B. Polypropylen, Polytetrafluorethylen oder Keramik, und mit Stiften ausgeführt ist, sorgt hierbei über eine (nicht dargestellte) Steuerungseinrichtung für die Synchronisation der Trägerbandgeschwindigkeit mit der Geschwindigkeit des Endlos-Metallbandes 12. Durch die magnetische Wechselwirkung zwischen dem Masken-Andrückband 24 und dem Magnetkopf 26 wird das Trägerband 30 fest auf die nicht zu beschichtende Rückseite des Endlos-Metallbandes 12 gedrückt oder gepresst, so dass dieses zur Reduzierung der Zugbelastung in dem eigentlichen Beschichtungsbereich fest auf dem Trägerband 30 aufliegt. Da je nach Beschichtungsproblem auch mehrere der beschriebenen Beschichtungsmodule oder Beschichtungssysteme 10 in einer Bandanlage zusammengefasst werden können (beispielsweise bis zu 8), könnte sich der Zug bei empfindlichen Bändern 12 ansonsten zu stark erhöhen und diese beschädigen.

Das zu beschichtende Endlos-Metallband 12 wird somit zusammen mit dem Trägerband 30, dem Maskenband 18 und dem Masken-Andrückband 24 als Einheit an dem Magnetkopf oder der Magneteinheit 26 vorbeigeführt oder -transportiert. Da diese Bänder 18, 24 und 30 aus verschleißfesten Materialien mit geringen Reibwerten bestehen, gibt es beim Transport keinen Schlupf, der die gewünschte hohe Präzision beim Aufbringen der Spots beeinträchtigen könnte.

Am Ende des Führungsweges für das Endlos-Metallband 12 sind in dem Selektiv-Beschichtungssystem 10 noch Luftabstreiferdüsen 34 zum Abblasen eventuell an dem Maskenband 18 anhaftender Elektrolytflüssigkeit angeordnet, so dass diese durch das umlaufende Maskenband 18 nicht unerwünschterweise mit auf die zu maskierende Oberfläche aufgetragen wird, was mit einer entsprechenden Verringerung der Selektivität verbunden wäre.

Da zu beschichtende Metallbänder 12 gegebenenfalls auch ferromagnetische Werkstoffe umfassen oder ferromagnetische Beschichtungswerkstoffe, wie z.B. Nickel aufgebracht werden, wird das auslaufende Metallband 12 (und eventuell in den vorhandenen Bändern vorhandene ferromagnetische Gegenmetalle) in einer an sich bekannten (nicht dargestellten) Entmagnetisierungseinrichtung vollständig entmagnetisiert.

Das beschriebene erfindungsgemäße Maskierungssystem mit dem Anoden-Anspritzkopf 16, dem Maskenband 18, den Umlenk- oder Führungsrollen 20a, 20b, den Positionierrollen 22a,22b dem Masken-Andrückband 24, dem Magnetkopf 26, dem Trägerband 30 und den Luftabstreiferdüsen 34 ist auf einem beweglichen Schlitten 36 gelagert, der mit Rollen 38 für die Schlittenbewegung versehen ist.

Auf der Metallband-Austrittsseite des Schlittens 36 ist eine erste Puffermagneteinrichtung 40 so angeordnet, dass sie mit einer gegenüberliegenden, zweiten gegenpoligen Puffermagneteinrichtung 42 an einer äußeren Rahmen- oder Trägereinrichtung 43 magnetisch wechselwirkt. Die Magnetstärke dieser beiden Puffermagneteinrichtungen 40, 42 ist hierbei so gewählt, dass die Schlittenbewegung bei einem zu großem Bandzug sanft gebremst und begrenzt wird.

Die Fahrbewegung des Schlitten 36 wird mittels einer Sensoreinrichtung 44 erfasst, die mit einer (nicht dargestellten) Steuerungseinrichtung zur Auswertung und Registrierung der Sensorsignale elektrisch verbunden ist. Diese ist wiederum mit dem Elektromotor 32 für den Antrieb des Trägerbandes 30 verbunden, der - angesteuert durch die Steuerungseinrichtung - die Geschwindigkeit des Trägerbandes 30 mit der Geschwindigkeit des Endlos-Metallbandes 12 synchronisiert.

Das vorstehend beschriebene erfindungsgemäße Maskierungssystem ist - für einen pH-Wert zwischen etwa 1 und 14 - chemisch resistent in wässrigen Lösungen, so dass zum Galvanisieren alle bekannten technisch wichtigen Elektrolyte einsetzbar sind. Durch das Galvanisierungssystem 10 können somit alle technisch wichtigen galvanisch abscheidbaren Metalle und Metalllegierungen, insbesondere Edelmetalle und Edelmetall-Legierungen, Zinn, Zinn-Blei, Kupfer und Nickel, selektiv abgeschieden werden. Durch geeignete Wahl des Maskenbandes 18 und des Masken-Andrückbandes 24 können hierbei auf flachen, flach- und formgestanzten Metallbändern sowohl Streifen als auch Spots unterschiedlicher Geometrie aufgebracht werden, wie beispielsweise Goldspotbeschichtungen aus galvanischen Goldcyanidelektrolyten oder Silberstreifenbeschichtungen auch aus cyanidhaltigen Elektrolyten. Hierbei ist eine Präzision des Randbereichs von weniger als 0,1 mm erreichbar. Gegebenenfalls können auch einseitige Vollbeschichtungen aufgebracht werden.

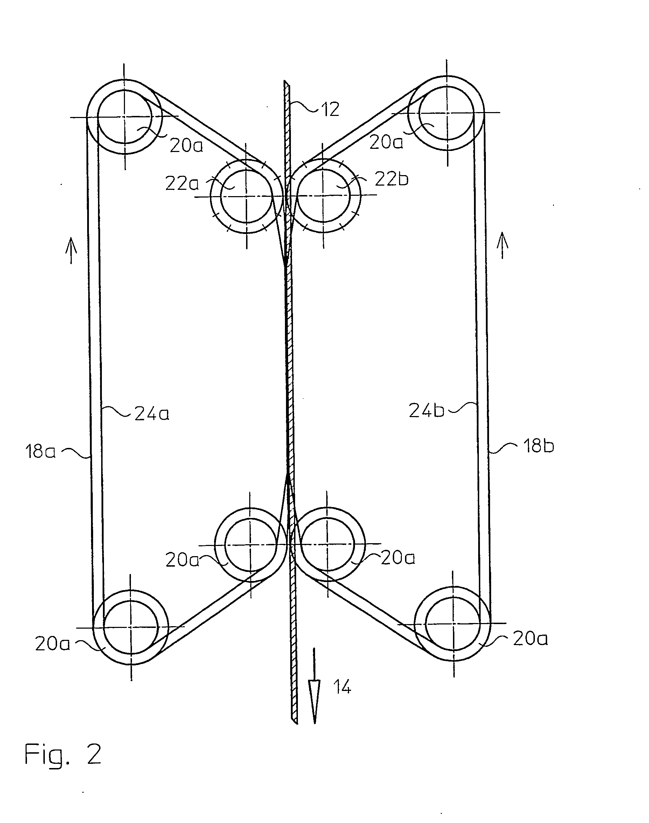

Zweiseitig zu beschichtende oder zu ätzende Endlos-Metallbänder 12 können beispielsweise mittels des in Fig. 2 dargestellten erfindungsgemäßen Doppel-Maskierungssystems 18, 20, 22, 24 maskiert werden. Das Doppel-Maskierungssystem 18, 20, 22, 24 umfasst zwei beidseitig eines Metallband-Führungsweges angeordnete und magnetisch miteinander wechselwirkende Maskierungseinrichtungen 18a, 20a, 22a und 24a bzw. 18b, 20b, 22b und 24b zum gleichzeitigen Maskieren der beiden zu bearbeitenden Metallbandseiten.

Ein zu bearbeitendes Endlos-Metallband 12 wird wiederum in Richtung des Pfeils 14 mit einer bestimmten Geschwindigkeit entlang eines Metallband-Führungsweges im Durchzugsverfahren von oben nach unten durch das Doppel-Maskierungssystems 18, 20, 22, 24 geführt, wobei die nicht maskierten freien Oberflächenbereiche gleichzeitig selektiv beschichtet oder geätzt werden. Das hierfür erforderliche eigentliche Beschichtungs- oder Ätzsystem, das beispielsweise eine geeignete Tauchgalvanikeinrichtung oder auch für jede der beiden Bandseiten einen oder mehrere Anspritzköpfe für einen geeigneten Elektrolyten oder ein Ätzmittel oder auch eine an sich bekannte sonstige Beschichtungs- oder Ätzeinrichtung, umfasst, ist zur besseren Übersichtlichkeit jedoch nicht dargestellt.

Die erste Maskierungseinrichtung 18a, 20a, 22a, 24a umfasst - entsprechend dem erfindungsgemäßen Ausführungsbeispiel gemäß Fig. 1 - wiederum ein geeignet strukturiertes Maskierungs- oder Maskenband 18a, das über Umlenk- oder Führungsrollen 20a und über eine Positionierrolle 22a im Uhrzeigersinn so im Kreis geführt wird, dass es in einem Beschichtungs- oder Ätzbereich parallel zu dem Endlos-Metallband 12 verläuft.

Auf der dem Endlos-Metallband 12 abgewandten Rückseite des Maskenbandes 18a ist ein erstes Masken-Andrückband 24a angeordnet, das synchron mit dem Maskenband 18a über die Umlenk- oder Führungsrollen 20a und über die Positionierrolle 22a bewegt wird. Bei dem Masken-Andrückband 24a handelt es sich wiederum um ein vollständig mit PTFE beschichtetes ferromagnetisches Eisenband.

Die zugeordnete zweite Maskierungseinrichtung oder Gegen-Maskierungseinrichtung 18b, 20b, 22b, 24b ist auf der gegenüberliegenden Seite des Metallband-Führungsweges bzw. des Endlos-Metallbandes 12 angeordnet. Sie umfasst ein geeignet strukturiertes Gegen-Maskenband 18b und ein auf der oberflächenabgewandten Seite dieses Gegen-Maskenbandes 18b angeordnetes zweites Masken-Andrückband oder Gegen-Masken-Andrückband 24b, die - entgegen dem Uhrzeigersinn - gleichfalls über Umlenk- oder Führungsrollen 20b und über eine Positionierrolle 22b so im Kreis geführt werden, dass sie im eigentlichen Beschichtungs- oder Ätzbereich parallel zu dem Endlos-Metallband 12 verlaufen.

Das Maskenband 18a und das Gegen-Maskenband 18b sind mit geeigneten Spots für die gewünschte selektive Oberflächenbehandlung versehen, welche je nach Anwendungszweck beliebig geformt oder gestaltet sei können. Die beiden Maskenbänder 18a und 18b bestehen jeweils wiederum aus gewebeverstärktem Polytetrafluorethylen (PTFE) mit einer Dicke von lediglich etwa 0,1 mm, so dass die gewünschten Spots mit einer hinreichend hohen Präzision von weniger als etwa 1 mm aufbringbar sind. Die beiden Maskenbänder 18a und 18b können hierbei sowohl identisch als auch unterschiedlich ausgebildet sein. Sie können bei Bedarf, wie z.B. bei der Herstellung von Streifen, gegebenenfalls auch wiederum mehrere einzelne sich parallel zueinander erstreckende Maskenbänder 18a bzw. 18b umfassen.

Das Gegen-Masken-Andrückband 24b umfasst eine Vielzahl (nicht dargestellter) eingelagerter Permanentmagnete, die so gewählt werden, dass die beiden Maskenbänder 18a und 18b in dem Beschichtungs- oder Ätzbereich infolge der magnetischen Wechselwirkung zwischen den beiden Masken-Andrückbändern 24a und 24b flüssigkeitsdicht auf die beiden zu bearbeitenden Oberflächen des Endlos-Metallbandes 12 gepreßt werden. Die zusammengepressten Bänder 24a, 18a, 12, 18b und 24b werden somit - entsprechend dem ersten Ausführungsbeispiels gemäß Fig. 1 - wiederum als Einheit durch den Beschichtungs- oder Ätzbereich transportiert.

Gegebenenfalls kann auch das Masken-Andrückband 24a entsprechend ausgebildet sein und eine Vielzahl eingelagerter Permanentmagnete umfassen, die bezüglich der Permanentmagnete in dem Gegen-Masken-Andrückband 24b magnetisch gegenpolig angeordnet werden, Es können auch Masken-Andrückbänder mit einem geeigneten magnetisierbaren Material, wie z.B. ein Barriumferrit-Pulver, eingesetzt werden, das mittels einer an sich bekannten geeigneten Magnetisiereinrichtung magnetisiert wird. Die beiden Masken-Andrückbänder 24a und 24b können bei manchen Anwendungszwecken gegebenenfalls auch mehrere einzelne, geeignet gestaltete, parallel zueinander geführte Masken-Andrückbänder 24a bzw. 24b umfassen.

Die Positionierrollen 22a und 22b sind mit Stiften zur ordnungsgemäßen Führung und Positionierung der beiden Maskenbänder 18a bzw. 18b bezüglich des zu beschichtenden Endlos-Metallbandes 12 und zur Synchronisierung der drei Bänder 12, 18a und 18b versehen. Die Positionierrollen 22a und 22b werden jeweils von einem (nicht dargestellten) Elektromotor angetrieben. Sie sind mit einem geeigneten nicht leitenden Material, wie z.B. Keramik, ausgeführt.

Die Umlenk- oder Führungsrollen 20a und 20b und die Positionierrollen 22a und 22b sind so angeordnet, dass sich der Abstand zwischen dem Maskenband 18a und dem zugeordneten Masken-Andrückband 24a einerseits sowie dem Gegen-Maskenband 18b und dem zugeordneten Gegen-Masken-Andrückband 24b andererseits allmählich verringert, Mit geringer werdendem Abstand zwischen den beiden magnetischen Masken-Andrückbändern 24a und 24b steigen entsprechend auch die Anziehungs- bzw. Haftkräfte, so dass die beiden Maskenbänder 18a und 18b vor dem eigentlichen Beschichtungs- oder Ätzbereich schonend auf die beiden zu bearbeitenden Metallbandoberflächen aufgebracht werden. Die vorliegende Maskierungseinrichtung kann daher insbesondere auch zur Maskierung empfindlicher formgestanzter Metallbänder genutzt werden.

Hinter dem Beschichtungs- oder Ätzbereich erfolgt das schonende Lösen der beiden Maskenbänder 18a und 18b von dem zu beschichtenden Metallband 12 umgekehrt durch eine langsame Abschwächung der für die Haftkräfte verantwortlichen Magnetfeldstärke infolge einer allmählichen Vergrößerung des Abstandes zwischen den beiden magnetischen Masken-Andrückbändern 24a und 24b durch eine geeignete Positionierung der Umlenk- oder Führungsrollen 20a und 20b.

Das beschriebene Doppel-Maskierungssystem 18, 20, 22, 24 ist - entsprechend dem ersten Ausführungsbeispiels gemäß Fig. 1 - wiederum auf einer (nicht dargestellten) beweglichen Schlitteneinrichtung gelagert, deren Bewegung durch eine magnetische Positioniereinrichtung gebremst und begrenzt wird. Die Schlittenbewegung wird auch im vorliegenden Fall durch eine (nicht dargestellte) zugeordnete Sensoreinrichtung erfasst und durch eine bewegungsabhängige Ansteuerung der beiden Elektromotoren für den Antrieb der Positionierrollen 22a und 22b so gesteuert, dass ein unzulässig hoher Zug in dem Endlos-Metallband 12 durch eine Synchronisation der Bandgeschwindigkeiten abgebaut wird.

Das vorliegende Doppel-Maskierungssystem 18, 20, 22, 24 kann gegebenenfalls auch zum einseitigen Maskieren des Endlos-Metallbandes 12 genutzt werden, indem eines der beiden Maskenbänder 18a oder 18b als Trägerband 30 genutzt oder einfach durch ein geeignetes Trägeband 30 ersetzt wird. Unter Umständen kann hierbei auch eines der beiden Maskenbänder 18a oder 18b entfallen und das zugeordnete Masken-Andrückband 24a bzw. 24b als Trägerband für dasEndlos-Metallband 12 genutzt werden.

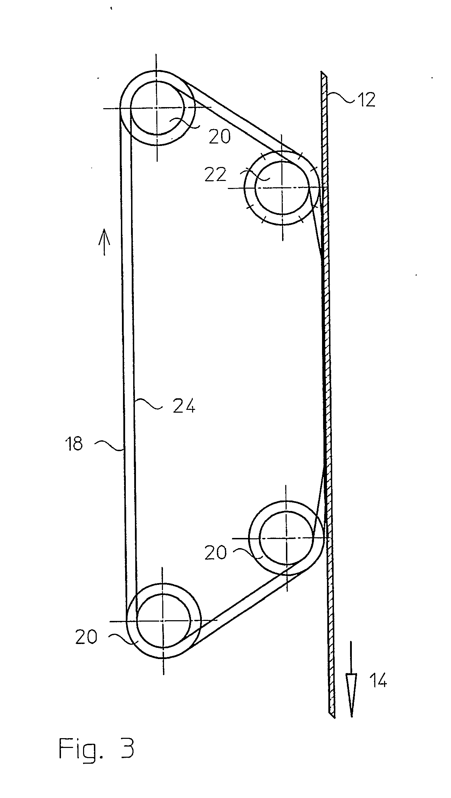

Das in Fig. 3 dargestellte erfindungsgemäße Maskierungssystem 18, 20, 22 und 24 dient zum einseitigen Maskieren eines ferromagnetischen Endlos-Metallbandes 12, das wiederum in Richtung des Pfeils 14 mit einer bestimmten Geschwindigkeit im Durchzugsverfahren von oben nach unten durch das Maskierungssystems 18, 20, 22 und 24 geführt wird. Die nicht maskierten freien Oberflächenbereiche werden hierbei gleichzeitig mittels einer an sich bekannten herkömmlichen Beschichtungs- oder Ätzeinrichtung selektiv beschichtet oder geätzt, die zur besseren Übersichtlichkeit jedoch wieder nicht dargestellt ist.

Das Maskierungssystem 18, 20, 22 und 24 umfasst wiederum ein geeignet strukturiertes Maskierungs- oder Maskenband 18 der oben genannten Art, das über Umlenk- oder Führungsrollen 20 und über eine durch einen (nicht dargestellten) Elektromotor angetriebene Positionierrolle 22 im Uhrzeigersinn so im Kreis geführt wird, dass es in einem Beschichtungs- oder Ätzbereich parallel zu dem ferromagnetischen Endlos-Metallband 12 verläuft.

Auf der dem Endlos-Metallband 12 abgewandten Rückseite des Maskenbandes 18 ist ein Masken-Andrückband 24 angeordnet, das synchron mit dem Maskenband 18 über die Umlenk- oder Führungsrollen 20 und über die Positionierrolle 22 bewegt wird. Das Masken-Andrückband 24 besteht aus gewebeverstärktem Polytetrafluorethylen mit eingelagerten Permanentmagneten, die so ausgelegt sind, dass das Maskenband 18 durch die magnetischen Anziehungskräfte zwischen dem Masken-Andrückband 24 einerseits und dem ferromagnetischen Endlos-Metallband 12 andererseits fest auf dessen zu bearbeitende Oberfläche gepresst wird und gemeinsam mit diesem und dem Masken-Andrückband 24 als Einheit durch den Beschichtungs- oder Ätzbereich transportiert wird.

Auf der maskenbandabgewandten Seite des Endlos-Metallbandes 12 kann wiederum eine (nicht dargestellte) geeignete Trägereinrichtung, wie beispielsweise ein über Umlenk-, Führungs- und Positionierrollen im Kreis geführtes Trägerband gemäß Fig. 1 angeordnet sein. Gegebenenfalls kann auch eine geeignete Auflage- oder Unterlageeinrichtung vorgesehen sein.

Auch dieses Maskierungssystem 18, 20, 22 und 24 ist wiederum auf einer (nicht dargestellten) beweglichen Schlitteneinrichtung gelagert, deren Bewegung durch eine magnetische Positioniereinrichtung gebremst und begrenzt wird. Die Schlittenbewegung wird auch im vorliegenden Fall durch eine (nicht dargestellte) zugeordnete Sensoreinrichtung erfasst und durch eine bewegungsabhängige Ansteuerung des oder der Bandantriebe so gesteuert, dass die Bandgeschwindigkeiten synchronisiert werden und ein unzulässig hoher Zug in dem Endlos-Metallband 12 abgebaut wird.

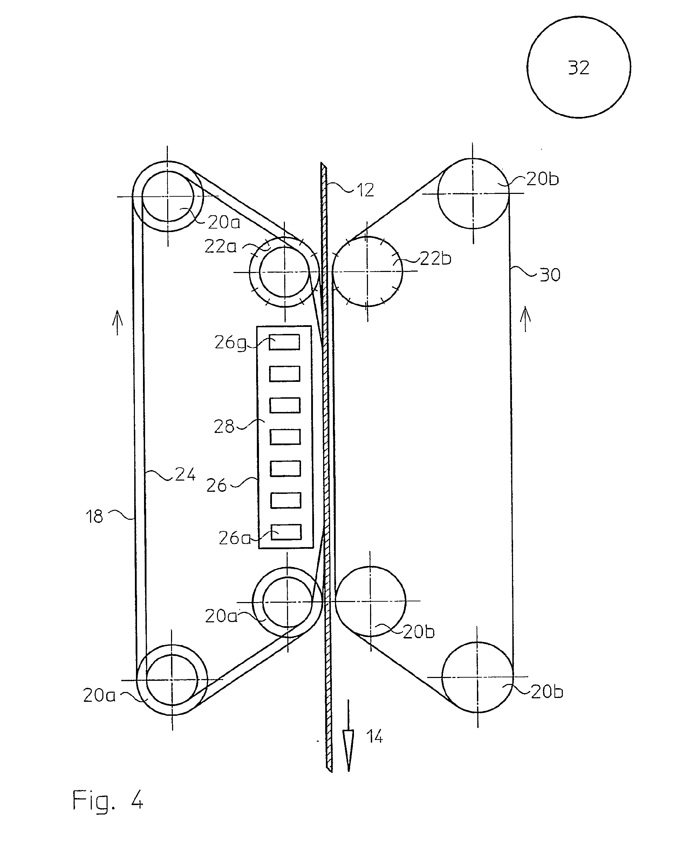

Bei dem in Fig. 4 dargestellten beispielhaften erfindungsgemäßen Maskierungssystem 18, 20, 22, 24, 26, 28, 30 und 32 wird das zu beschichtende Endlos-Metallband 12 - entsprechend den bisherigen Ausführungsbeispielen - wiederum in Pfeilrichtung 14 durch das Maskierungssystems 18, 20, 22, 24, 26, 28, 30 und 32 geführt und hierbei gleichzeitig mittels einer (nicht dargestellten) geeigneten herkömmlichen Beschichtungs- oder Ätzeinrichtung selektiv beschichtet oder geätzt.

Das Maskierungssystem 18, 20, 22, 24, 26, 28,30 und 32 umfasst einen Magnetkopf 26 mit mehreren äquidistant zueinander angeordneten Elektromagneten 26a - 26g, die mit einer etwa 2 mm dicken PTFE-Beschichtung 28 versehen. Die Elektromagnete 26a - 26g ermöglichen eine leichte Anpassung der Magnetkräfte an das jeweilige Beschichtungsproblem. Sie können in Abhängigkeit von der jeweiligen Dicke und Verbiegungsempfindlichkeit des Endlos-Metallbandes 12 geeignet gewählt und bedarfsgerecht eingestellt werden. Gegebenenfalls können in dem Magnetkopf 26 jedoch auch einer oder mehrere geeignete Permanentmagnete verwendet werden.

Um den Magnetkopf 26 wird wieder ein geeignet strukturiertes Maskierungs- oder Maskenband 18 der oben genannten Art über Umlenk- oder Führungsrollen 20 und über eine durch einen (nicht dargestellten) Elektromotor angetriebene Positionierrolle 22 im Uhrzeigersinn so im Kreis geführt wird, dass es in einem Beschichtungs- oder Ätzbereich parallel zu dem Endlos-Metallband 12 verläuft.

Auf der dem Endlos-Metallband 12 abgewandten und dem Magnetkopf 26 zugewandten Rückseite des Maskenbandes 18 ist ein Masken-Andrückband 24 angeordnet, das synchron mit dem Maskenband 18 über die Umlenk- oder Führungsrollen 20a und über die Positionierrolle 22a bewegt wird. Das Masken-Andrückband 24 besteht aus gewebeverstärktem Polytetrafluorethylen mit eingelagerten Permanentmagneten, deren Polung und Magnetstärke so gewählt wird, dass das Maskenband 18 durch die abstoßenden Magnetkräfte zwischen dem Magnetkopf 26 und dem Masken-Andrückband 24 flüssigkeitsdicht auf die zu beschichtende Vorderseite des Endlos-Metallbandes 12 gepreßt wird. Die drei genannten Bänder 12, 18 und 24 werden somit wieder als Einheit durch den Beschichtungs- oder Ätzbereich transportiert.

Auf der nicht zu bearbeitenden gegenüberliegenden Seite des Endlos-Metallbandes 12 wird wieder - gemäß dem ersten Ausführungsbeispiel in Fig. 1 - ein aus gewebeverstärktem PTFE bestehendes und von einem durch eine (nicht dargestellte) Steuerungseinrichtung bedarfsgerecht gesteuerten Elektromotor 32 angetriebenes Trägerband 30 über Umlenk- oder Führungsrollen 20b und eine Positionierrolle 22b entgegen dem Uhrzeigersinn so im Kreis geführt, dass es im Beschichtungs- oder Ätzbereich parallel zu dem Endlos-Metallband 12 verläuft. Die Positionierrolle 22b sorgt hierbei wiederum für eine Synchronisation der Trägerbandgeschwindigkeit mit der Geschwindigkeit des Endlos-Metallbandes 12, das durch die auf über das Masken-Andrückband 24a und das Maskenband 18 übertragenen Magnetkräfte fest auf das Trägerband 30 gedrückt oder gepresst wird.

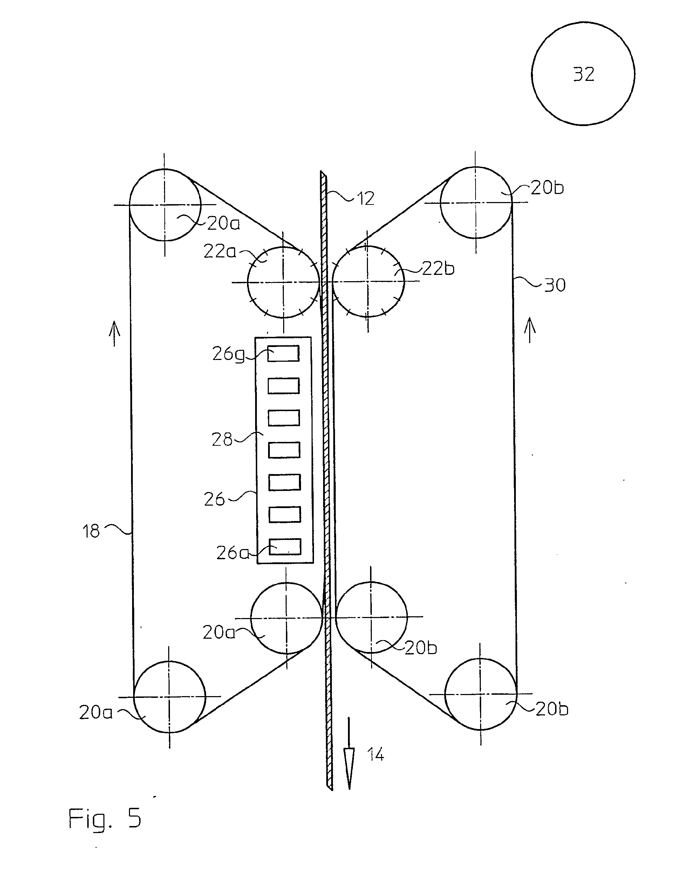

Bei dem in Fig. 5 dargestellten letzten erfindungsgemäßen Ausführungsbeispiel wurden das Maskenband 18 und das Masken-Andrückband 24 im Vergleich zu dem Maskierungssystem gemäß Fig. 4 als Einheit ausgebildet, so dass das Masken-Andrückband 24 als eigenständiges Bauteil entfällt. Das Maskenband 18 ist dafür als magnetischer Gegenpol zu dem Magnetkopf 26 ausgebildet. Es besteht aus gewebeverstärktem Polytetrafluorethylen mit eingelagerten Permanentmagneten, die so ausgelegt sind, dass das Maskenband 18 durch die magnetischen Abstoßungskräfte des gegenpoligen Magnetkopfs 26 fest auf das Endlos-Metallband 12 gedrückt wird.

Die vorliegende Erfindung wurde vorstehend anhand der Beschichtung, insbesondere der galvanischen Beschichtung, oder des Ätzens eines Endlos-Metallbandes beispielhaft erläutert. Es sei jedoch darauf hingewiesen, dass das erfindungsgemäße Beschichtungs- oder Ätzverfahren auch bei zahlreichen anderen Gegenständen oder Werkstücken anwendbar ist, die durch das beschriebene Magnet-Maskierungsverfahren sehr einfach, schnell, zuverlässig und präzise maskierbar sind. Beispielhaft sei hier nur noch das Auftragen nichtmetallischer Beschichtungsstoffe, wie z.B. Farben, Lacke oder dergleichen, auf eine Vielzahl an metallischen und nichtmetallischen Materialien, das Einätzen von Oberflächen. z.B. bei Glas, oder das Durchätzen von geometrischen Gebilden oder Gegenständen genannt.

## Patentansprüche

1. Verfahren zum selektiven Beschichten oder Ätzen von Oberflächen, insbesondere bei Metallbändern (12), metallisierten Bändern oder bandförmig angeordneten metallischen oder metallisierten Gegenständen, durch:
- Maskieren der Oberflächen mit einer Maskierungseinrichtung, die durch eine magnetische Wechselwirkung zwischen einer Magneteinrichtung und einer Gegen-Magneteinrichtung flüssigkeitsdicht angedrückt oder angepresst wird, von denen zumindest eine auf der oberflächenabgewandten Seite der Maskierungseinrichtung angeordnet ist; und
- Beschichten oder Ätzen der nicht maskierten Oberflächenbereiche,
**dadurch gekennzeichnet,**
**dass** eine unzulässig starke Krafteinwirkung auf zu beschichtende oder zu ätzende Gegenstände erfasst und durch eine Veränderung der Betriebsparameter der Maskierungseinrichtung oder der beiden Magneteinrichtungen automatisch kompensiert wird.

2. Verfahren nach Anspruch 1,
**dadurch gekennzeichnet,**
**dass** zwei sich gegenüberliegende Oberflächenbereiche gleichzeitig beschichtet oder geätzt werden.

3. Verfahren nach Anspruch 1 oder 2,
**dadurch gekennzeichnet,**
**dass** eine bandförmig ausgebildete Maskierungseinrichtung verwendet wird.

4. Verfahren nach einem der vorhergehenden Ansprüche,
**dadurch gekennzeichnet,**
**dass** eine Maskierungseinrichtung aus Kunststoff, insbesondere Polytetrafluorethylen (PTFE), oder aus einem entsprechend beschichteten Metall oder einer Metalllegierung verwendet wird.

5. Verfahren nach einem der vorhergehenden Ansprüche,
**dadurch gekennzeichnet,**
**dass** eine Maskierungseinrichtung mit einer Dicke von 0,1 - 2 mm verwendet wird.

6. Verfahren nach einem der vorhergehenden Ansprüche,
**dadurch gekennzeichnet,**
**dass** eine ferromagnetische Magneteinrichtung und eine Gegen-Magneteinrichtung mit einem oder mehreren Permanent- oder Elektromagneten verwendet werden.

7. Verfahren nach Anspruch 6,
**dadurch gekennzeichnet,**
**dass** als Gegen-Magneteinrichtung ein Magnetkopf (26) mit einem oder mehreren Permanent- oder Elektromagneten (26a,...,26g) verwendet wird.

8. Verfahren nach einem der vorhergehenden Ansprüche,
**dadurch gekennzeichnet,**
**dass** eine Magneteinrichtung und eine Gegen-Magneteinrichtung mit jeweils einem oder mehreren Permanent- oder Elektromagneten verwendet werden.

9. Verfahren nach einem der vorhergehenden Ansprüche,
**dadurch gekennzeichnet,**
**dass** eine bandförmig ausgebildete Magneteinrichtung und eine bandförmig ausgebildete Gegen-Magneteinrichtung verwendet werden.

10. Verfahren nach einem der vorhergehenden Ansprüche,
**dadurch gekennzeichnet,**
**dass** eine Magneteinrichtung und eine Gegen-Magneteinrichtung verwendet werden, die mit Polytetrafluorethylen (PTFE) beschichtet sind oder mit einem anderen vergleichbar gut thermisch beständigen, chemikalien- und verschleißfesten Kunststoff mit einem entsprechend niedrigen Reibwert.

11. Verfahren nach einem der vorhergehenden Ansprüche,
**dadurch gekennzeichnet,**
**dass** Kunststoff-Beschichtungen mit einer Dicke von 0,1 - 2 mm verwendet werden.

12. Verfahren nach einem der vorhergehenden Ansprüche,
**dadurch gekennzeichnet,**
**dass** die Oberflächen durch Aufspritzen, Aufsprühen, Aufpinseln, Aufwalzen eines geeigneten flüssigen Beschichtungs- oder Ätzmediums, durch Eintauchen in dieses Medium oder durch Ausnutzung von Kapillarkräften beschichtet oder geätzt werden.

13. Verfahren nach einem der vorhergehenden Ansprüche,
**dadurch gekennzeichnet,**
**dass** die nicht maskierten Oberflächenbereiche selektiv galvanisiert werden.

14. Verfahren nach einem der vorhergehenden Ansprüche,
**dadurch gekennzeichnet,**
**dass** vorhandene Metalle oder Metalllegierungen parallel zur Nord-/Südpolrichtung der Magneteinrichtungen ausgerichtet werden.

15. Verfahren nach einem der vorhergehenden Ansprüche,
**dadurch gekennzeichnet,**
**dass** das Beschichtungs- oder Ätzmaterial im Kreislauf geführt und filtriert wird und dass vorhandene ferromagnetische Metallpartikel magnetisch abgeschieden werden.

16. Verfahren nach einem der vorhergehenden Ansprüche,
**dadurch gekennzeichnet,**
**dass** zu verarbeitende Gegenstände und in der Magneteinrichtung oder in der Maskierungseinrichtung vorhandene Gegenmetalle nach dem Beschichten oder Ätzen entmagnetisiert werden.

17. Verfahren nach einem der vorhergehenden Ansprüche,
**dadurch gekennzeichnet,**
**dass** die Oberflächen unter magnetischer Abschirmung beschichtet oder geätzt werden.

18. Verfahren nach einem der vorhergehenden Ansprüche,
**dadurch gekennzeichnet,**
**dass** die Krafteinwirkung anhand einer Bewegung der Magneteinrichtung und/oder der Gegen-Magneteinrichtung erfasst wird und dass diese Bewegung magnetisch gebremst und begrenzt wird.

19. Beschichtungs- oder Ätzsystem zum selektiven Beschichten oder Ätzen von Oberflächen, insbesondere bei Metallbändern (12), metallisierten Bändern oder bandförmig angeordneten metallischen oder metallisierten Gegenständen, mit:
- einer Halte-, Führungs- und/oder Transporteinrichtung für zu beschichtende oder zu ätzende Gegenstände;
- einer Beschichtungs- oder Ätzeinrichtung; und
- einem Maskierungssystem, das
- eine Maskierungseinrichtung zum Maskieren nicht zu beschichtender oder zu ätzender Oberflächenbereiche mit einer mit diesen Oberflächenbereichen in Kontakt bringbaren oder in Kontakt stehenden Oberflächen-Kontaktseite und einer gegenüberliegenden Rückseite;
- eine Magneteinrichtung; und
- eine Gegen-Magneteinrichtung
umfasst, wobei die beiden Magneteinrichtungen so angeordnet und ausgebildet sind, dass die Maskierungseinrichtung durch eine magnetische Wechselwirkung zwischen ihnen flüssigkeitsdicht auf die Oberfläche gepreßt wird oder aufpreßbar ist,
**gekennzeichnet durch**:
- eine Schlitteneinrichtung (36) für die Maskierungseinrichtung und für die beiden Magneteinrichtungen mit
- einer automatischen Positioniereinrichtung und
- einer Sensoreinrichtung (44) zur Erfassung einer Schlittenbewegung; und
- eine Steuerungs- und Korrektureinrichtung zur Erfassung der Sensorsignale und zur automatischen Kompensation unerwünschter oder unzulässiger Betriebsbedingungen **durch** eine Veränderung der Betriebsparameter.

20. Beschichtungs- oder Ätzsystem nach Anspruch 19,
**dadurch gekennzeichnet,**
**dass** die Maskierungseinrichtung eine Maske und eine Gegenmaske zum Maskieren zweier sich gegenüberliegender Oberflächenbereiche umfasst,

21. Beschichtungs- oder Ätzsystem nach Anspruch 19 oder 20,
**dadurch gekennzeichnet,**
**dass** die Maskierungseinrichtung und die Magneteinrichtung integral ausgebildet sind.

22. Beschichtungs- oder Ätzsystem nach einem der Ansprüche 19-21,
**dadurch gekennzeichnet,**
**dass** die Maskierungseinrichtung bandförmig, insbesondere als Endlosband (18), ausgebildet ist.

23. Beschichtungs- oder Ätzsystem nach einem der Ansprüche 19 - 22,
**dadurch gekennzeichnet,**
**dass** die Maskierungseinrichtung aus Metall oder Kunststoff, insbesondere Polytetrafluorethylen (PTFE), besteht.

24. Beschichtungs- oder Ätzsystem nach einem der Ansprüche 19 - 23,
**dadurch gekennzeichnet,**
**dass** die Dicke der Maskierungseinrichtung 0,1 - 2 mm beträgt.

25. Beschichtungs- oder Ätzsystem nach einem, der Ansprüche 19- 24,
**dadurch gekennzeichnet,**
**dass** die Magneteinrichtung ein ferromagnetisches Material und die Gegen-Magneteinrichtung einen oder mehrere Permanent- oder Elektromagnete umfassen.

26. Beschichtungs- oder Ätzsystem nach Anspruch 25,
**dadurch gekennzeichnet,**
**dass** die Permanent- oder Elektromagnete in einem Magnetkopf (26) angeordnet sind.

27. Beschichtungs- oder Ätzsystem nach einem der Ansprüche 19-24,
**dadurch gekennzeichnet,**
**dass** die Magneteinrichtung und die Gegen-Magneteinrichtung jeweils ein oder mehrere Permanent- oder Elektromagnete umfassen.

28. Beschichtungs- oder Ätzsystem nach einem der Ansprüche 19-27,
**dadurch gekennzeichnet,**
**dass** die Magneteinrichtung und/oder die Gegen-Magneteinrichtung bandförmig, insbesondere als Endlosband, ausgebildet sind.

29. Beschichtungs- oder Ätzsystem nach einem der Ansprüche 19-28,
**dadurch gekennzeichnet,**
**dass** die Magneteinrichtung und/oder die Gegen-Magneteinrichtung mit Polytetrafluorethylen (PTFE) beschichtet sind oder mit einem anderen vergleichbar gut thermisch beständigen, chemikalien- und verschleißfesten Kunststoff mit einem entsprechend niedrigen Reibungswert.

30. Beschichtungs- oder Ätzsystem nach Anspruch 29,
**dadurch gekennzeichnet,**
**dass** die Dicke der Beschichtung 0,1 - 2 mm beträgt.

31. Beschichtungs- oder Ätzsystem nach einem der Ansprüche 19-30,
**dadurch gekennzeichnet,**
**dass** die Positioniereinrichtung magnetisch abstoßende Positioniermagnete (40, 42) umfasst, die so angeordnet und ausgelegt sind, dass sie bei einem zu starken Bandzug eine Fahrbewegung der Schlitteneinrichtung (36) in Bandzugrichtung ermöglichen.

32. Beschichtungs- oder Ätzsystem nach einem der Ansprüche 19-31,
**dadurch gekennzeichnet,**
**dass** die Beschichtungs- oder Ätzeinrichtung eine Aufspritz-, Aufsprüh-, Aufpinsel-, Aufwalz-, Eintauch- oder Kapillareinrichtung umfasst.

33. Beschichtungs- oder Ätzsystem nach einem der Ansprüche 19 - 32,
**dadurch gekennzeichnet,**
**dass** die Beschichtungseinrichtung eine Elektrolyseeinrichtung umfasst.

34. Beschichtungs- oder Ätzsystem nach einem der Ansprüche 19-33,
**dadurch gekennzeichnet,**
**dass** die Halte-, Führungs- und/oder Transporteinrichtung so ausgelegt ist, dass die Gegenstände parallel zur Nörd-/Südpolrichtung der Magneteinrichtungen ausgerichtet sind.

35. Beschichtungs- oder Ätzsystem nach einem der Ansprüche 19 - 34,
**gekennzeichnet durch**,
eine Filtereinrichtung zum Filtrieren des verwendeten Beschichtungs- oder Ätzmaterials und/oder eine Abscheideeinrichtung zum Abscheiden vorhandener ferromagnetischer Metallpartikel.

36. Beschichtungs- oder Ätzsystem nach einem der Ansprüche 19 - 35,
**gekennzeichnet durch**,
eine Entmagnetisierungseinrichtung für die zu verarbeitenden Gegenstände.

37. Beschichtungs- oder Ätzsystem nach einem der Ansprüche 19 - 36,
**gekennzeichnet durch**,
eine Abschirmungseinrichtung zum magnetischen Abschirmen des Systems.

## Claims

1. Method for selectively coating or etching surfaces, particularly for metal bands (12), metallized bands or metallic or metallized objects arranged in band form, by:
- masking the surfaces with a masking device which is applied or pressed on liquid-tightly by a magnetic interaction between a magnet device and a counter magnet device, at least one of which is arranged on the other side of the masking device from the surface; and
- coating or etching the unmasked surface regions,
**characterized in that** an impermissibly strong force exerted onto the objects to be coated or etched is detected and automatically compensated for by modifying the operating parameters of the masking device or the two masking devices.

2. Method according to Claim 1, **characterized in that** two mutually opposite surface regions are simultaneously coated or etched.

3. Method according to Claim 1 or 2, **characterized in that** a masking device designed in band form is used.

4. Method according to one of the preceding claims, **characterized in that** a masking device made of plastic, in particular polytetrafluoroethylene (PTFE), or a correspondingly coated metal or a metal alloy is used.

5. Method according to one of the preceding claims, **characterized in that** a masking device with a thickness of 0.1 - 2 mm is used.

6. Method according to one of the preceding claims, **characterized in that** a ferromagnetic magnet device and a counter magnet device having one or more permanent magnets or electromagnets are used.

7. Method according to Claim 6, **characterized in that** a magnetic head (26) having one or more permanent magnets or electromagnets (26a,..., 26g) is used as the counter magnet device.

8. Method according to one of the preceding claims, **characterized in that** a magnet device and a counter magnet device each having one or more permanent magnets or electromagnets are used.

9. Method according to one of the preceding claims, **characterized in that** a magnet device designed in band form and a counter magnet device designed in band form are used.

10. Method according to one of the preceding claims, **characterized in that** a magnet device and a counter magnet device are used, which are coated with polytetrafluoroethylene (PTFE) or with another plastic of comparably good thermal stability, chemical and wear resistance with a correspondingly low friction value.

11. Method according to one of the preceding claims, **characterized in that** plastic coatings with a thickness of 0.1 - 2 mm are used.

12. Method according to one of the preceding claims, **characterized in that** the surfaces are coated or etched by atomizing, spraying, brushing or rolling a suitable liquid coating medium or etching medium, by immersion into this medium or by the use of capillary forces.

13. Method according to one of the preceding claims, **characterized in that** the unmasked surface regions are selectively galvanized.

14. Method according to one of the preceding claims, **characterized in that** metals or metal alloys which are present are aligned parallel to the north/south pole direction of the magnet devices.

15. Method according to one of the preceding claims, **characterized in that** the coating or etching material is circulated and filtered, and **in that** ferromagnetic metal particles which are present are magnetically separated.

16. Method according to one of the preceding claims, **characterized in that** objects to be processed and counter metals which are present in the magnet device or in the masking device are demagnetized after the coating or etching.

17. Method according to one of the preceding claims, **characterized in that** the surfaces are coated or etched with magnetic screening.

18. Method according to one of the preceding claims, **characterized in that** the force exerted is detected with the aid of a movement of the magnet device and/or the counter magnet device, and **in that** this movement is mechanically braked and limited.

19. Coating or etching system to selectively coat or etch surfaces, particularly for metal bands (12), metallized bands or metallic or metallized objects arranged in band form, having:
- a holding, guiding and/or transporting device for objects to be coated and/or etched;
- a coating or etching device; and
- a masking system, which comprises
- a masking device to mask surface regions not to be coated or etched, having a surface contact side which can be brought in contact or is in contact with these surface regions and an opposite rear side;
- a magnet device; and
- a counter magnet device,
the two magnet devices being arranged and designed so that the masking device is pressed or can be pressed liquid-tightly onto the surface by a magnetic interaction between them;
**characterized by**
- a carriage device (36) for the masking device and for the two magnet devices, having
- an automatic positioning device and
- a sensor device (44) to detect a carriage movement;
and
- a control and correction device to detect the sensor signals and to automatically compensate for undesired or impermissible operational conditions by a modification of the operating parameters.

20. Coating or etching system according to Claim 19, **characterized in that** the masking device comprises a mask and a counter mask to mask two mutually opposite surface regions.

21. Coating or etching system according to Claim 19 or 20, **characterized in that** the masking device and a magnet device are formed integrally.

22. Coating or etching system according to one of Claims 19 - 21, **characterized in that** the masking device is designed in band form, in particular as an endless band (18).

23. Coating or etching system according to one of Claims 19 - 22, **characterized in that** the masking device consists of metal or plastic, in particular polytetrafluoroethylene (PTFE).

24. Coating or etching system according to one of Claims 19 - 23, **characterized in that** the thickness of the masking device is 0.1 - 2 mm.

25. Coating or etching system according to one of Claims 19 - 24, **characterized in that** the magnet device comprises a ferromagnetic material and the counter magnet device comprises one or more permanent magnets or electromagnets.

26. Coating or etching system according to Claim 25, **characterized in that** the permanent magnets or electromagnets are arranged in a magnetic head (26).

27. Coating or etching system according to one of Claims 19 - 24, **characterized in that** the magnet device and the counter magnet device each comprise one or more permanent magnets or electromagnets.

28. Coating or etching system according to one of Claims 19 - 27, **characterized in that** the magnet device and/or the counter magnet device are designed in band form, in particular as an endless band.

29. Coating or etching system according to one of Claims 19 - 28, **characterized in that** the magnet device and/or the counter magnet device are coated with polytetrafluoroethylene (PTFE) or with another plastic of comparably good thermal stability, chemical and wear resistance with a correspondingly low friction value.

30. Coating or etching system according to Claim 29, **characterized in that** the thickness of the coating is 0.1 - 2 mm.

31. Coating or etching system according to one of Claims 19 - 30, **characterized in that** the positioning device comprises magnetically repellable positioning magnets (40, 42), which are arranged and configured so that they permit a travelling movement of the carriage device (36) in the band tension direction in the event of an excessive band tension.

32. Coating or etching system according to one of Claims 19 - 31, **characterized in that** the coating or etching device comprises an atomizing, spraying, brushing, roller, immersion or capillary device.

33. Coating or etching system according to one of Claims 19 - 32, **characterized in that** the coating device comprises an electrolysis device.

34. Coating or etching system according to one of Claims 19 - 33, **characterized in that** the holding, guiding and/or transporting device is configured so that the objects are aligned parallel to the north/south pole direction of the magnet devices.

35. Coating or etching system according to one of Claims 19 - 34, **characterized by** a filter device to filter the used coating or etching material and/or a separating device to separate ferromagnetic metal particles which are present.

36. Coating or etching system according to one of Claims 19 - 35, **characterized by** a demagnetizing device for the objects to be processed.

37. Coating or etching system according to one of Claims 19 - 36, **characterized by** a screening device to magnetically screen the system.

## Revendications

1. Procédé pour revêtir ou graver sélectivement des surfaces, en particulier des feuillards métalliques (12), des feuillards métallisés ou des objets métalliques ou métallisés disposés en bandes, par :
- masquage des surfaces par un dispositif de masquage qui est repoussé ou comprimé de manière étanche aux liquides par interaction magnétique entre un dispositif magnétique et un dispositif magnétique complémentaire dont au moins l'un est disposé sur le côté du dispositif de masquage non tourné vers la surface et
- revêtement ou gravure des parties non masquées de la surface,
**caractérisé en ce que**
une action insuffisamment élevée de la force sur les objets à revêtir ou à graver est détectée et est automatiquement compensée par une modification des paramètres de fonctionnement du dispositif de masquage ou des deux dispositifs magnétiques.

2. Procédé selon la revendication 1, **caractérisé en ce que** deux zones de surface mutuellement opposées sont revêtues ou gravées simultanément.

3. Procédé selon les revendications 1 ou 2, **caractérisé en ce que** l'on utilise un dispositif de masquage en forme de bande.

4. Procédé selon l'une des revendications précédentes, **caractérisé en ce que** l'on utilise un dispositif de masquage en matière synthétique, en particulier en polytétrafluoroéthylène (PTFE), en métal revêtu de manière appropriée ou en alliage de métaux.

5. Procédé selon l'une des revendications précédentes, **caractérisé en ce que** l'on utilise un dispositif de masquage d'une épaisseur de 0,1 à 2 mm.

6. Procédé selon l'une des revendications précédentes, **caractérisé en ce que** l'on utilise un dispositif magnétique ferromagnétique et un dispositif magnétique complémentaire qui présente un ou plusieurs aimants permanents ou électroaimants.

7. Procédé selon la revendication 6, **caractérisé en ce que** comme dispositif magnétique complémentaire, on utilise une tête magnétique (26) qui présente un ou plusieurs aimants permanents ou électroaimants (26a, ..., 26g).

8. Procédé selon l'une des revendications précédentes, **caractérisé en ce que** l'on utilise un dispositif magnétique et un dispositif magnétique complémentaire qui présentent tous deux un ou plusieurs aimants permanents ou électroaimants.

9. Procédé selon l'une des revendications précédentes, **caractérisé en ce que** l'on utilise un dispositif magnétique configuré en forme de bande et un dispositif magnétique complémentaire configuré en forme de bande.

10. Procédé selon l'une des revendications précédentes, **caractérisé en ce que** l'on utilise un dispositif magnétique et un dispositif magnétique complémentaire revêtus de polytétrafluoroéthylène (PTFE) ou d'une autre matière synthétique qui présente des propriétés comparables de tenue à la chaleur et de résistance aux produits chimiques et à l'usure.

11. Procédé selon l'une des revendications précédentes, **caractérisé en ce que** l'on utilise des revêtements en matière synthétique d'une épaisseur de 0,1 à 2 mm.

12. Procédé selon l'une des revendications précédentes, **caractérisé en ce que** les surfaces sont revêtues ou gravées par projection, pulvérisation, application à la brosse, application au cylindre d'un agent liquide de revêtement ou de gravure, par immersion dans ce fluide ou en utilisant les forces capillaires.

13. Procédé selon l'une des revendications précédentes, **caractérisé en ce que** les parties non masquées de la surface sont galvanisées de manière sélective.

14. Procédé selon l'une des revendications précédentes, **caractérisé en ce que** les métaux ou alliages de métaux présents sont orientés parallèlement à la direction entre les pôles nord et sud des dispositifs magnétiques.

15. Procédé selon l'une des revendications précédentes, **caractérisé en ce que** le matériau de revêtement de gravure est mis en circulation et filtré en circuit fermé et **en ce que** les particules de métal ferromagnétique présentes sont séparées magnétiquement.

16. Procédé selon l'une des revendications précédentes, **caractérisé en ce que** les objets à traiter et les métaux complémentaires présents dans le dispositif magnétique ou dans le dispositif de masquage sont démagnétisés après revêtement ou gravure.

17. Procédé selon l'une des revendications précédentes, **caractérisé en ce que** les surfaces sont revêtues ou gravées en étant blindées magnétiquement.

18. Procédé selon l'une des revendications précédentes, **caractérisé en ce que** l'action de la force est détectée à l'aide d'un déplacement du dispositif magnétique et/ou du dispositif magnétique complémentaire et **en ce que** ce déplacement est freiné et limité magnétiquement.

19. Système de revêtement ou de gravure pour revêtir ou graver sélectivement des surfaces, en particulier des feuillards métalliques (12), des feuillards métallisés ou des objets métalliques ou métallisés disposés en forme de bande, qui présente :
- un dispositif de maintien, de guidage et/ou de transport des objets à revêtir ou à graver,
- un dispositif de revêtement ou de gravure et
- un système de masquage qui comprend :
- un dispositif de masquage qui masque les parties de surface qui ne doivent pas être revêtues ou gravées par un côté de contact avec la surface qui peut être amenée en contact avec ses parties de surface ou qui est en contact avec elles et un côté arrière opposé,
- un dispositif magnétique et
- un dispositif magnétique complémentaire,
les deux dispositifs magnétiques étant disposés et configurés de telle sorte que le dispositif de masquage peut être repoussé ou comprimé de manière étanche aux liquides contre la surface par interaction magnétique entre eux,
**caractérisé par** :
- un dispositif à chariot (36) pour le dispositif de masquage ou pour les deux dispositifs de masquage, qui présente
- un dispositif de positionnement automatique et
- un dispositif de détection (44) qui détecte le déplacement du chariot et
- un dispositif de commande et de correction qui détecte les signaux des détecteurs et qui compense automatiquement des conditions indésirables ou inadmissibles de fonctionnement par une modification des paramètres de fonctionnement.

20. Système de revêtement ou de gravure selon la revendication 19, **caractérisé en ce que** le dispositif de masquage comprend un masque et un masque complémentaire qui masquent deux parties de surface opposées l'une à l'autre.

21. Système de revêtement ou de gravure selon les revendications 19 ou 20, **caractérisé en ce que** le dispositif de masquage et le dispositif magnétique sont configurés d'un seul tenant.

22. Système de revêtement ou de gravure selon l'une des revendications 19 à 21, **caractérisé en ce que** le dispositif de masquage est réalisé en forme de bande et en particulier en forme de bande sans fin (18).

23. Système de revêtement ou de gravure selon l'une des revendications 19 à 22, **caractérisé en ce que** le dispositif de masquage est constitué de métal ou de matière synthétique et en particulier de polytétrafluoroéthylène (PTFE).

24. Système de revêtement ou de gravure selon l'une des revendications 19 à 23, **caractérisé en ce que** l'épaisseur du dispositif de masquage est de 0,1 à 2 mm.

25. Système de revêtement ou de gravure selon l'une des revendications 19 à 24, **caractérisé en ce que** le dispositif magnétique comprend un matériau ferromagnétique et le dispositif magnétique complémentaire un ou plusieurs aimants permanents ou électroaimants.

26. Système de revêtement ou de gravure selon la revendication 25, **caractérisé en ce que** les aimants permanents ou électroaimants sont disposés dans une tête magnétique (26).

27. Système de revêtement ou de gravure selon l'une des revendications 19 à 24, **caractérisé en ce que** le dispositif magnétique et le dispositif magnétique complémentaire comprennent tous deux un ou plusieurs aimants permanents ou électroaimants.

28. Système de revêtement ou de gravure selon l'une des revendications 19 à 27, **caractérisé en ce que** le dispositif magnétique et/ou le dispositif magnétique complémentaire sont configurés en forme de bande et en particulier en forme de bande sans fin.

29. Système de revêtement ou de gravure selon l'une des revendications 19 à 28, **caractérisé en ce que** le dispositif magnétique et/ou le dispositif magnétique complémentaire sont revêtus de polytétrafluoroéthylène (PTFE) ou d'une autre matière synthétique qui présente des propriétés comparables de tenue à la chaleur et de résistance aux produits chimiques et à l'usure et dont le coefficient de frottement est suffisamment bas.

30. Système de revêtement ou de gravure selon la revendication 29, **caractérisé en ce que** l'épaisseur du revêtement est de 0,1 à 2 mm.

31. Système de revêtement ou de gravure selon l'une des revendications 19 à 30, **caractérisé en ce que** le dispositif de positionnement comprend des aimants de positionnement (40, 42) qui se repoussent magnétiquement et qui sont disposés et conçus de manière à permettre un déplacement du dispositif à chariot (36) dans la direction de traction de la bande lorsque la traction de la bande est trop importante.

32. Système de revêtement ou de gravure selon l'une des revendications 19 à 31, **caractérisé en ce que** le dispositif de revêtement ou de gravure comprend un dispositif de projection, de pulvérisation, d'application au pinceau, d'application au rouleau, d'immersion ou capillaire.

33. Système de revêtement ou de gravure selon l'une des revendications 19 à 32, **caractérisé en ce que** le dispositif de revêtement comprend un dispositif d'électrolyse.

34. Système de revêtement ou de gravure selon l'une des revendications 19 à 33, **caractérisé en ce que** le dispositif de maintien, de guidage et/ou de transport est conçu de telle sorte que les objets soient orientés parallèlement à la direction qui relie les pôles nord et sud des dispositifs magnétiques.

35. Système de revêtement ou de gravure selon l'une des revendications 19 à 34, **caractérisé par** un dispositif de filtration qui filtre le matériau utilisé de revêtement ou de gravure et/ou un dispositif de séparation qui sépare les particules de métal ferromagnétique éventuellement présentes.

36. Système de revêtement ou de gravure selon l'une des revendications 19 à 35, **caractérisé par** un dispositif de démagnétisation des objets à traiter.

37. Système de revêtement ou de gravure selon l'une des revendications 19 à 36, **caractérisé par** un dispositif de blindage qui blinde magnétiquement le système.
